# EUROPEAN PATENT SPECIFICATION

(11) **EP 1 902 462 B1**
(45) Date of publication and mention of the grant of the patent: **13.06.2012**
(21) Application number: 06787042.8
(22) Date of filing: 12.07.2006
(51) Int. Cl.: H01L 21/67

(54) **FLUID DEPOSITION CLUSTER TOOL**
CLUSTERWERKZEUG ZUR FLUIDABSCHEIDUNG
OUTIL MULTIPLE DE DEPOT DE FLUIDE

(30) Priority: 13.07.2005 US 699437 P; 13.07.2005 US 699436 P
(43) Date of publication of application: 26.03.2008
(73) Proprietor: Fujifilm Dimatix, Inc., Lebanon, NH 03766 (US)
(72) Inventor: HIGGINSON, John A., Santa Clara, CA 95051 (US); ROCCHIO, Michael, Hayward, CA 94541 (US); BIRKMEYER, Jeffrey, San Jose, CA 95125 (US); DEMING, Stephen R., San Jose, CA 95127 (US); VON ESSEN, Kevin, San Jose, CA 95118 (US); BIBL, Andreas, Los Altos, CA 94024 (US); GARDNER, Deane A., Cupertino, CA 95014-1043 (US)
(74) Representative: Peterreins, Frank
(86) International application number: PCT/US2006/027081
(87) International publication number: WO 2007/009000

(56) References cited:
- US-A1- 2002 132 052
- US-A1- 2004 096 586

## Description

### TECHNICAL FIELD

The following description relates to depositing fluid onto a substrate.

### BACKGROUND

A cluster tool generally includes multiple processing modules and a robotic transfer system. For example, cluster tools are used in semiconductor manufacturing. Such a cluster tool is an integrated device that consists of several single wafer processing modules and a wafer transport module based on a robot. The cluster tool may function in a clean room environment, requiring operators to don appropriate apparel so as not to contaminate the environment.

Depositing a fluid onto a substrate is a common task that is performed in a variety of applications, e.g., a printer is a typical example of a fluid deposition device for printing ink onto paper or another form of substrate. Depending on the application, depositing fluids onto a substrate may require participation of a human operator. At the same time, it may also be required that fluid deposition be performed in an environment that is potentially harmful to the human operator. For example, fluid deposition can involve high temperatures, harmful fluids, and so on. Accordingly, it may preferable to isolate the human operator from the environment in which fluid deposition is performed.
[0003.1] U.S. Patent Publication 2004/0096586 describes an automated deposition system includes a template deposition chamber that is used to deposit a mesostructured template on a wafer or other substrate, such as an optical lens. A supercritical infusion chamber infuses the mesoporous template with a matrix-forming material that is cured to produce a mesoporous matrix. The template may be removed by thermal, chemical or plasma processing to leave the mesoporous matrix intact.
[0003.1] U.S. Patent Publication 2002/0132052 describes single wafer processing methods and systems for manufacturing films having low-k properties and low indices of refraction. The methods incorporate a processing station in which both curing and post-cure, in situ gas cooling take place.

### SUMMARY

Apparatus and methods for depositing a fluid onto a substrate are described. In general, in one aspect, the invention features a cluster tool including a main chamber, a load chamber, a fluid deposition chamber, a robot and an environmental controller. The load chamber is coupled to the main chamber and configured to receive one or more substrates. The fluid deposition chamber is coupled to the main chamber and includes a fluid deposition device configured to deposit fluid onto the one or more substrates. The robot is included in the main chamber and is configured to transfer the one or more substrates between the load chamber and the fluid deposition chamber. The environmental controller is configured to maintain a substantially autonomous environment within the cluster tool.

Implementations of the invention can include one or more of the following features. The cluster tool can further include a low temperature cure chamber coupled to the main chamber and configured to perform a low temperature cure operation on the one or more substrates, and a high temperature cure chamber coupled to the main chamber and configured to perform a high temperature cure operation on the one or more substrates. The load chamber can include an interior door coupled to the main chamber and one or more exterior faces, wherein the load chamber is configured to receive the one or more substrates through an exterior door in at least one of the one or more exterior faces.

The fluid deposition chamber can include an interior opening coupled to the main chamber and one or more exterior faces. The fluid deposition chamber can further include a rapid transfer port and/or one or more gloves sealed to one or more of the exterior faces and extending into the fluid deposition chamber. The environmental controller can include a gas purification system configured to control a gas composition inside the chambers included in the cluster tool. The environmental controller can further include a processor configured to provide control signals to the gas purification system to control a gas composition included within the chambers of the cluster tool. Controlling the gas composition inside the chambers included in the cluster tool can include controlling a level of moisture inside the chambers included in the cluster tool.

The cluster tool can further include a processor configured to provide control signals to the robot. The processor can be further configured to provide control signals to one or more of the chambers coupled to the main chamber included in the cluster tool. The cluster tool can further include a human machine interface configured to receive user input to control the cluster tool.

In general, in another aspect, the invention features a cluster tool comprising a main chamber, a load chamber, a fluid deposition chamber, a low temperature cure chamber, a high temperature cure chamber, a robot and an environmental controller. The load chamber is coupled to the main chamber and configured to receive one or more substrates. The fluid deposition chamber is coupled to the main chamber and includes a fluid deposition device configured to deposit fluid onto the one or more substrates. The low temperature cure chamber is coupled to the main chamber and configured to perform a low temperature cure operation on the one or more substrates. The high temperature cure chamber is coupled to the main chamber and configured to perform a high temperature curing operation on the one or more substrates. The robot is within the main chamber and is configured to transfer the one or more substrates between the chambers included in the cluster tool. The environmental controller is configured to maintain a substantially autonomous environment within the cluster tool.

Implementations of the invention can include one or more of the following features. The environmental controller can include a gas purification system configured to control a gas composition inside the chambers included in the cluster tool. The environmental controller can further include a processor configured to provide control signals to the gas purification system to control a gas composition included within the chambers of the cluster tool. Controlling the gas composition inside the chambers included in the cluster tool can include controlling a level of moisture inside the chambers included in the cluster tool. The cluster tool can further include a processor configured to provide control signals to the robot. The processor can be configured to provide control signals to one or more of the chambers coupled to the main chamber included in the cluster tool. The cluster tool can further include a human machine interface configured to receive user input to control the cluster tool.

In general, in another aspect, the invention features a method of depositing a fluid on a substrate. A substantially autonomous environment is maintained within a cluster tool, the cluster tool including a main chamber including a robot, a load chamber coupled to the main chamber, and a fluid deposition chamber coupled to the main chamber. One or more substrates are loaded into the load chamber and an enviromnent inside the load chamber is equilibrated with an environment inside the main chamber. The robot transfers at least one of the one or more substrates from the load chamber into the fluid deposition chamber, the fluid deposition chamber including a fluid deposition device configured to deposit fluid onto the one or more substrates. A fluid is deposited from the fluid deposition device onto the at least one substrate.

Implementations of the invention can include one or more of the following features. The cluster tool can further include a low temperature cure chamber and a high temperature cure chamber. The robot can transfer the at least one substrate from the fluid deposition chamber into the low temperature cure chamber. A low temperature cure operation can be performed on the at least one substrate. The robot can transfer the at least one substrate from the fluid deposition chamber into the high temperature cure chamber. A high temperature cure operation can be performed on the at least one substrate. The robot can transfer the at least one substrate from the high temperature cure chamber into the load chamber. The at least one substrate can be unloaded from the load chamber. While a first substrate is in the low temperature cure chamber, the robot can transfer a second substrate from the load chamber into the fluid deposition chamber. The fluid deposition operation can occur at least in part on the second substrate while the low temperature cure operation occurs on the first substrate.

Implementations of the invention can realize one or more of the following advantages. The fluid deposition cluster tool maintains a substantially autonomous environment permitting fluid deposition operations to occur under controlled conditions. Because the fluid deposition cluster tool can operate without user interaction within the autonomous environment, an operator of the cluster tool can be isolated from a potentially harmful and/or inhabitable environment (e.g., high temperatures, harmful fluids/gases, and so on). Conversely, the cluster tool is protected from potential contamination from the operator.

The details of one or more embodiments of the invention are set forth in the accompanying drawings and the description below. Other features, objects, and advantages of the invention will be apparent from the description and drawings, and from the claims.

### DESCRIPTION OF DRAWINGS

FIG. 1A is a schematic representation of a fluid deposition cluster tool.

FIG 1B is a top view of a fluid deposition cluster tool.

FIG 1C is a perspective view of the cluster tool of FIG 1B.

FIG 2 is an expanded view of a load chamber.

FIG 3A is an expanded rear view of a fluid deposition chamber.

FIG 3B is an expanded front view of a fluid deposition chamber.

FIG 3C is a schematic representation of a fluid deposition chamber.

FIG. 4A shows a fluid deposition device.

FIG 4B shows a schematic representation of a fluid deposition device coupled to a processor.

FIG 5 shows the fluid deposition device of FIG 4A without the housing.

FIGS. 6A-E show a cartridge mount assembly of the fluid deposition device of FIG 4A.

FIGS. 7A-B show a cap assembly included in the cartridge mount assembly of FIGS. 6A-C.

FIGS. 8A-C show an alternative cap assembly included in the cartridge mount assembly of FIGS. 6A-C.

FIG. 9 is an expanded view of a low temperature cure chamber.

FIG 10 is an expanded view of a high temperature cure chamber.

FIG. 11 is a schematic representation of a controller.

FIG 12 is a flowchart illustrating a process for using a fluid deposition cluster tool to process a substrate.

Like reference symbols in the various drawings indicate like elements.

### DETAILED DESCRIPTION

A fluid deposition cluster tool is described that includes a fluid deposition chamber for depositing fluid onto a substrate using a fluid deposition device. The fluid deposition chamber is coupled to a main chamber including a substrate transport system, *i.e.,* a robot. A load chamber is also coupled to the main chamber, thereby allowing a substrate to be loaded into the load chamber and transferred into the fluid deposition chamber via the main chamber using the robot. The fluid deposition cluster tool further includes an environmental controller configured to maintain a substantially autonomous environment within the cluster tool. As a result, the environment outside of the cluster tool has minimal effect on the environment within the cluster tool and visa versa.

An exemplary fluid disposition tool is a printer and a typical printing fluid is ink. However, it should be understood that other fluids can be used, for example, electroluminescent material used in the manufacture of light emitting displays or liquid metals used in circuit board fabrication.

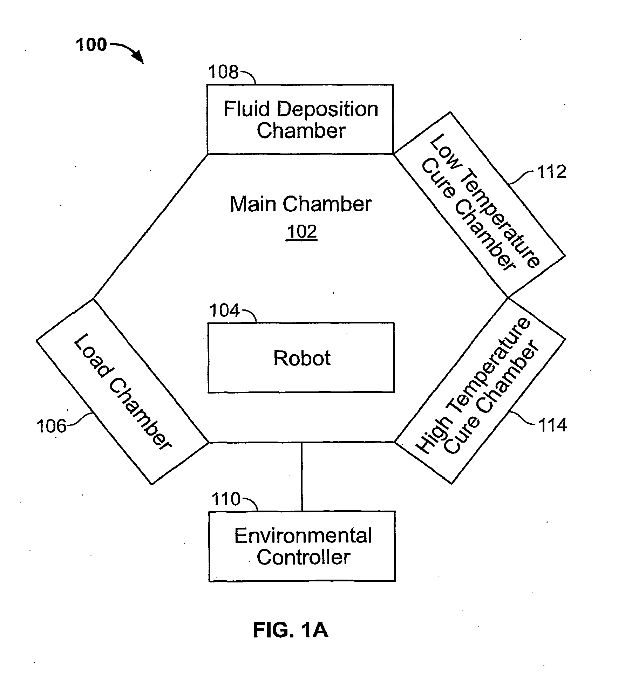

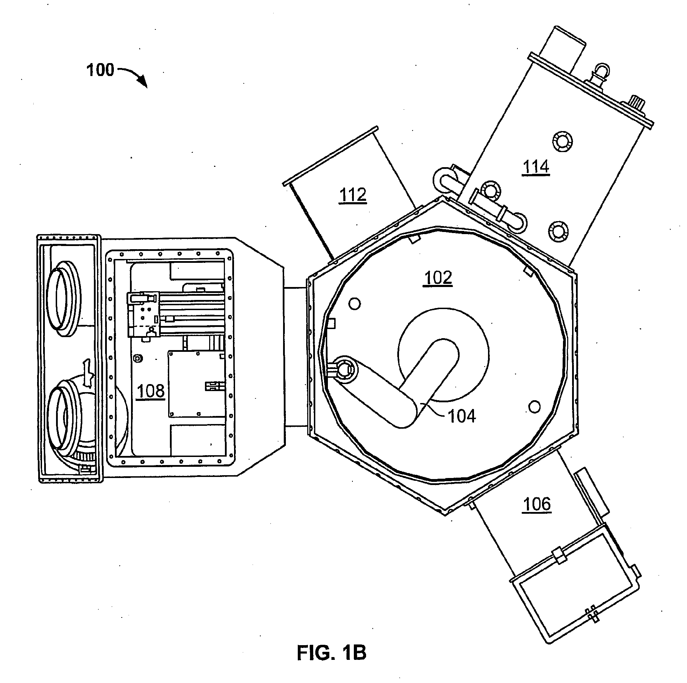

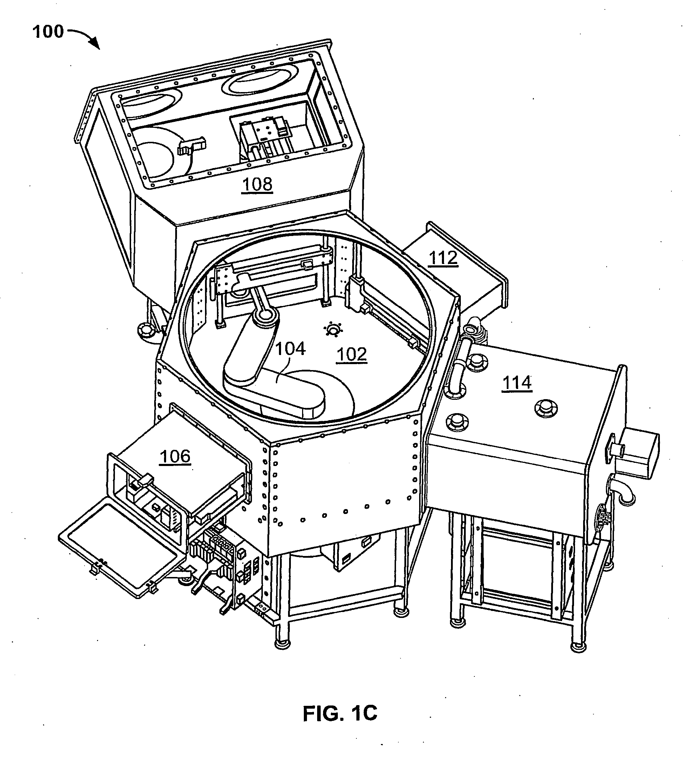

FIGS. 1A, 1B, and 1C respectively show a schematic representation, a top view, and a perspective view of one implementation of a fluid deposition cluster tool 100. The fluid deposition cluster tool 100 includes a main chamber 102 coupled to multiple chambers, at least one of which is a fluid deposition chamber 108. In this embodiment, the main chamber 102 is shaped approximately as a hexagon and four chambers are coupled to four of the six faces of the main chamber 102. In other embodiments, the main chamber 102 can be shaped differently, including more or fewer faces. Additionally, in another embodiment, two or more chambers can be coupled to the main chamber 102 on a single face, and may be arranged vertically relative to one another and/or horizontally.

Referring again to the embodiment of the fluid deposition cluster tool 100 shown in FIG. 1A, the main chamber 102 includes a robot 104 that is configured to transfer a substrate between different chambers included in the fluid deposition cluster tool 100. Any robot can be used, for example, an R-Theta robot such as the IR-820 atmospheric wafer handling robot available from Innovative Robotics, San Jose, CA.

The fluid deposition cluster tool 100 further includes a load chamber 106 coupled to the main chamber 102. The load chamber 106 is configured for transfer of one or more substrates to and from the fluid deposition cluster tool 100. A fluid deposition chamber 108 is also coupled to the main chamber 102, and includes a fluid deposition device, e.g., a printer, for depositing fluid on the substrate. In this implementation, the fluid deposition cluster tool 100 further includes a low temperature cure chamber 112 and a high temperature cure chamber 114, both of which are coupled to the main chamber 102.

The fluid deposition cluster tool 100 further includes an environmental controller 110. As previously mentioned, the environmental controller 110 maintains a substantially autonomous environment within the fluid deposition cluster tool 100. In one implementation, maintaining a substantially autonomous environment within the fluid deposition cluster tool 100 includes maintaining a substantially moisture-free, pure nitrogen environment inside the fluid deposition cluster tool 100.

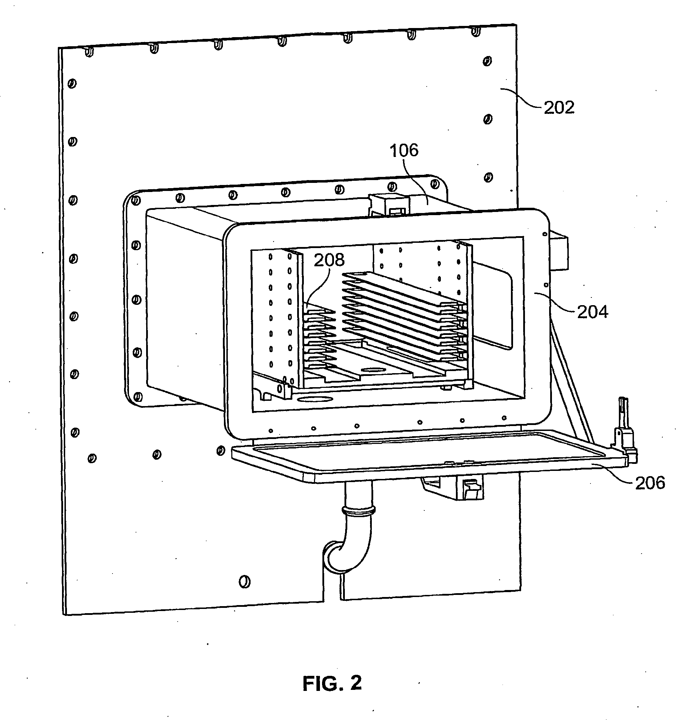

Referring now to FIGS. 2-6, the various chambers coupled to the main chamber 102 shall be described in further detail. Referring particularly to FIG. 2, an expanded view of the load chamber 106 according to one implementation is shown. The load chamber 106 is connected to a panel 202 that attaches to a face of the main chamber 102. The load chamber 106 includes an interior door (not shown) sealing the interior of the load chamber 106 from the main chamber 102, and an exterior door 206 sealing the load chamber 106 from the exterior environment. The interior door of the load chamber 106 can remain closed when the environment of the load chamber 106 is substantially different from the environment of the main chamber 102, e.g., immediately after the exterior door 206 has been opened to load or unload the load chamber 106, thereby contaminating the environment inside the load chamber 106.

The load chamber 106 can be equilibrated to the environment of the main chamber 102 before the interior door of the load chamber 106 is opened to allow transfer of substrates between the load chamber 106 and the main chamber 102. In this embodiment, the load chamber 106 is connected directly to a vacuum pump included in a gas purification system included in the environmental controller 110. The contaminated gas within the load chamber 106 is removed by the vacuum pump and exhausted (*i.e.,* not recirculated), and gas having the desired gas composition (*e.g.*, dry, nitrogen gas) is pumped into the load chamber. The contaminated gas is vacuumed out while the desired gas is pumped in diluting the contaminated environment until an acceptable level of the desired gas is achieved, which can be determined by sampling and testing the atmosphere within the load chamber.

Substrates can be loaded into the load chamber 106 in a variety of ways. In one implementation, substrates can be placed on shelves 208 included in the load chamber 106 by a human operator when the exterior door 206 is open. The shelves 208 are configured and spaced from one another so that the robot's arm can extend beneath a substrate positioned on a shelf 208, raise up and contact the substrate, and withdraw the substrate from the load chamber 106 into the main chamber 102 through the interior door. In another implementation, a cassette including shelves can be loaded outside of the load chamber 106, and then inserted as a single unit (*i.e*., the cassette loaded with one or more substrates) into the load chamber 106, thereby reducing the amount of time the load chamber is open to the exterior environment.

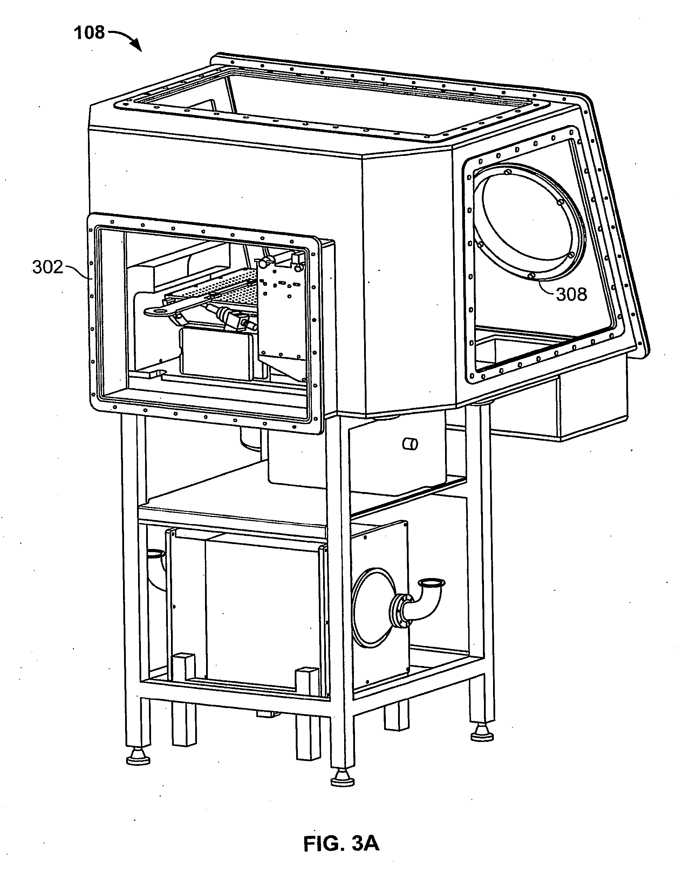

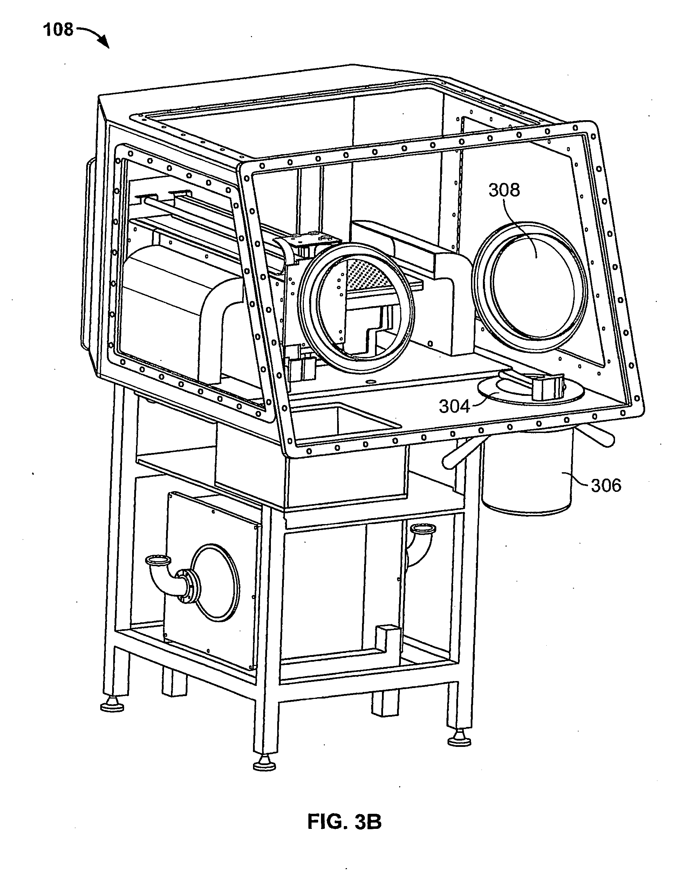

Referring now to FIGS. 3A and 3B, an expanded rear view and an expanded front view of a fluid deposition chamber 108 are shown respectively, according to one implementation. Referring particularly to FIG. 3A, the fluid deposition chamber 108 includes an interior face 302 that couples to the main chamber 102. The interior face 302 of the fluid deposition chamber 108 includes an opening through which the robot 104 can transfer substrates between the main chamber 102 and the fluid deposition chamber 108. Optionally, an interior door can be included at the interface of the fluid deposition chamber 108 to the main chamber 102, for example, to seal the fluid deposition chamber 108 during a fluid deposition operation.

Referring more particularly to FIG. 3B, the fluid deposition chamber 108 further includes one or more exterior faces. In the embodiment shown, at least a portion of some of the exterior faces are transparent, *e.g*., made from a clear plexiglass material, allowing the operator to see within the fluid deposition chamber 108. An exterior face of the fluid deposition chamber 108 can include a transfer door 304 for transferring items (*e.g*., printer cartridges, tools, and so on) in and out of the fluid deposition chamber 108. Items can be transferred using a conventional rapid transfer port 306 (RTP).

Generally, an RTP 306 is a fluid tight hollow body that can be sealed so the environment within the RTP 306 is not substantially influenced by the environment external to the RTP 306. For example, the RTP 306 can be a hollow cylinder, where the top surface is a sealable door that can be fastened onto the transfer door 304 of the fluid deposition chamber 108. Once the door of the RTP 306 is fastened to the transfer door 304 of the fluid deposition chamber 108, the two doors can open and close together. As a result, items can be transferred in and out of the fluid deposition chamber 108 without exposing the fluid deposition chamber 108 to the outside environment, thereby potentially contaminating the fluid deposition chamber 108. However, the fluid deposition chamber 108 is exposed to the environment contained within the RTP 306. Accordingly, the RTP 306 is preferably loaded in a closed environment that is substantially the same as the environment within the fluid deposition chamber 108, for example, using a sealed glovebox.

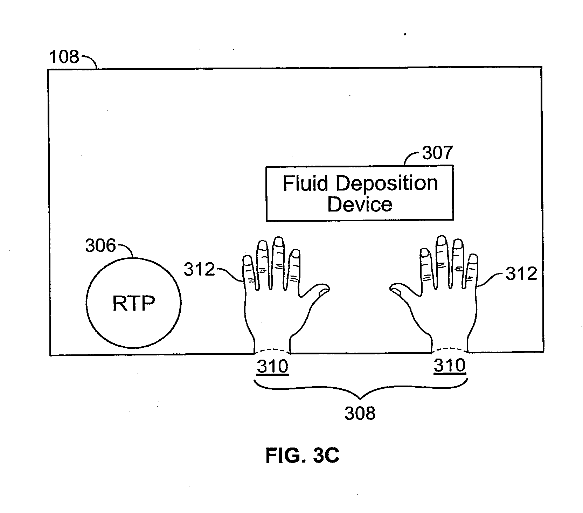

The fluid deposition chamber 108 can further include one or more glove ports 308. For illustrative purposes, the gloves that can seal to the ports 308 are not shown, as they would obscure the view of other components within the chamber 108. Referring to FIG. 3C, a schematic representation of the fluid deposition chamber 108 including the gloves 312 attached and sealed to the glove ports 308 is shown. A human operator of the fluid deposition chamber 108 can insert his or her hands into the gloves 312 and work within the fluid deposition chamber 108 using the gloves 312, e.g., to assemble items inside the chamber, perform maintenance procedures, move items into and out of the RTP 306, and so on, without contaminating the environment of the fluid deposition chamber 108. As will be described later, fluid deposition chamber 108, in one implementation, operates in a substantially pure nitrogen environment. Accordingly, a glove port 308 allows the operator to move items (*e.g*., printer cartridges, tools, and so on) in and out of the fluid deposition chamber 108 without contaminating the gas composition within the fluid deposition chamber 108 and without being exposed to the nitrogen environment.

The fluid deposition chamber 108 further includes a fluid deposition device 307. For example, an inkjet printer can be the fluid deposition device 307. In one implementation, the fluid deposition device 307 can be a fluid deposition device as described in further detail in U.S. Patent Publication 2007/0013736.

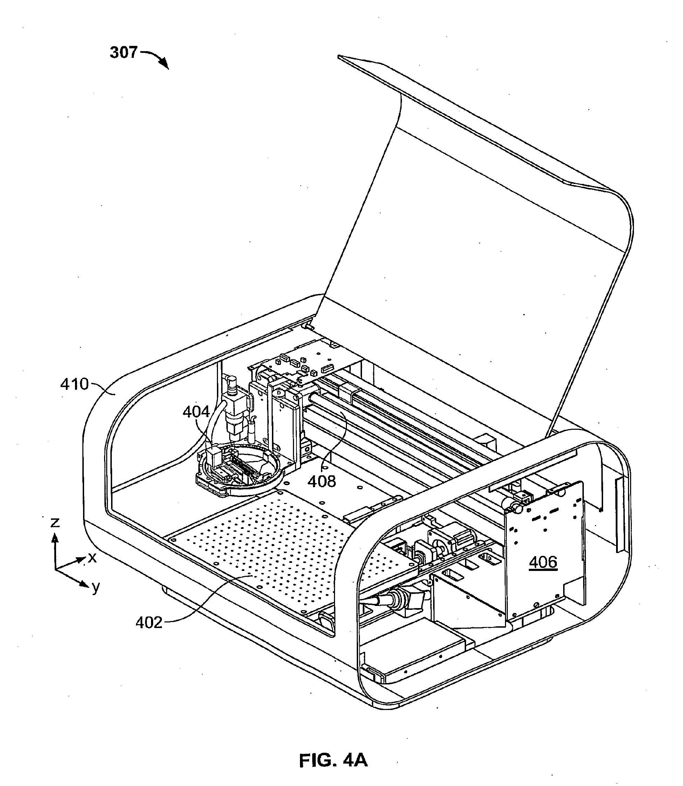

This implementation is described below in reference to FIGS. 4A-8C. However, it should be understood that other embodiments of fluid deposition device can be used and the fluid deposition device described herein is just one example described for illustrative purposes.

The fluid deposition device 307 includes a cartridge mount for mounting a print cartridge and a platen for supporting a substrate upon which a fluid is to be deposited. The print cartridge and substrate move relative to one another during a print operation. In one implementation, the print cartridge passes over a stationary substrate, and in another implementation the print cartridge remains stationary while the substrate advances. It should be noted that a print cartridge is sometimes referred to as a drop ejection module, printhead module, or otherwise.

Referring to FIG. 4A, one embodiment of a fluid deposition device 307 is shown. The fluid deposition device 307 includes a platen 402 configured to support a substrate during a print operation. A cartridge mount assembly 404 is attached to a frame 406 and positioned above the platen 402. The cartridge mount assembly 404 can translate along a rail 408 in the y-direction, providing movement relative to a substrate positioned on the platen 402. Additionally, the cartridge mount assembly 404 can move upward and downward relative to the platen 402, *i.e.,* in the z-direction, to provide relative vertical movement between a print cartridge mounted therein and the substrate.

The platen 402 is configured to advance forward and backward in the x-direction. For example, after the cartridge mount assembly 404 has made a first pass of the substrate (*i.e*., translated the whole or a partial distance along the width of the substrate in the y-direction), the platen 402 can advance in the x-direction. When the cartridge mount assembly 404 does a next pass of the substrate, the print cartridge will deposit fluid on a different portion of the substrate. The fluid deposition device 307 is shown enclosed within a housing 410 that can be used to provide a substantially clean, contamination free zone for a print operation to occur. The housing 410 is optional, particularly when the fluid deposition device 307 is within the fluid deposition chamber 108.

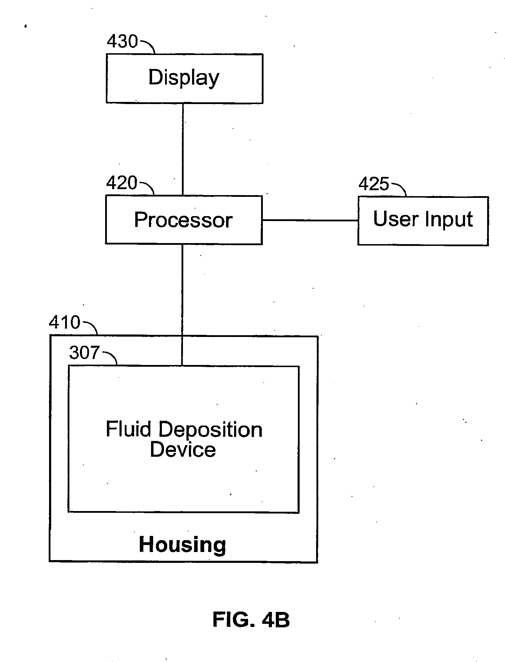

Referring to FIG. 4B, a schematic representation of the fluid deposition device 307 is shown. In this implementation, the fluid deposition device 307 is coupled to a processor 420. The processor 420 can be connected to a display 430 (*e.g*., a monitor) and a user input device 425 (*e.g*., a keyboard and/or mouse). The processor 420 can provide instructions to various components of the fluid deposition device 307, as shall be described further below. The display 430 and user input device 425 can allow a user to input operation parameters and make adjustments to a fluid deposition process, as well as view feedback provided by the processor 420, as described further below.

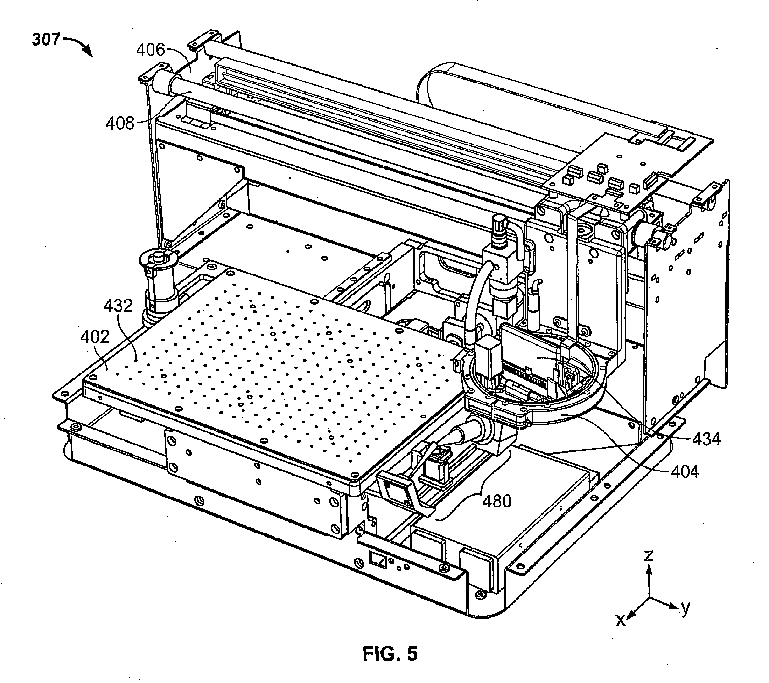

Referring to FIG. 5, an enlarged view of the fluid deposition device 307 without the optional housing 410 is shown. The platen 402 includes multiple apertures 432 connected to a vacuum source. The vacuum source and apertures 432 can operate to vacuum chuck a substrate to the platen 402. In other implementations, other techniques can be used to secure the substrate to the platen 402, including, for example, clips or screws. The platen 402 is configured to advance incrementally in the x-direction. A motor is included within the fluid deposition device 307 beneath the platen 402 and operates to advance the platen 402 forward and backward in the x-direction. For example, in one implementation the motor can be positioned beneath the platen 402 and include a lead screw on the motor's shaft. The lead screw is anchored to the underside of the platen 402, and as the lead screw translates along the shaft, the platen 402 is pushed or pulled in the x-direction. The platen 402 can move along guide rails to ensure the platen 402 moves in the x-direction.

Additionally, a linear encoder can be included beneath the platen 402 to monitor the position of the platen 402. The accuracy of the encoder is matched to the accuracy requirements of the ink dot placement. For example, for relatively high resolution printing, a linear encoder accurate to approximately five microns can be used. In one implementation, the platen 402 can include lift pins configured to lift a substrate off the platen's upper surface to facilitate a robot picking up the substrate from the platen 402. The lift pins may or may not be retractable into the platen so as to position the substrate substantially flat against the platen during a fluid deposition operation.

The cartridge mount assembly 404 is shown in a rest position off to one side of the platen 402. A print cartridge 434 is shown mounted within the cartridge mount assembly 404. The cartridge mount assembly 404 can translate in the y-direction along the rail 408 by way of a motor attached to the frame 406 and including a belt extending substantially the length of the rail 408. The belt is anchored to the cartridge mount assembly 404 and pulls the cartridge mount assembly 404 back and forth in the y-direction along the rail 408 as the motor's shaft (coupled to the belt) rotates. Other configurations of motor assembly can be used, including different placement of the motor.

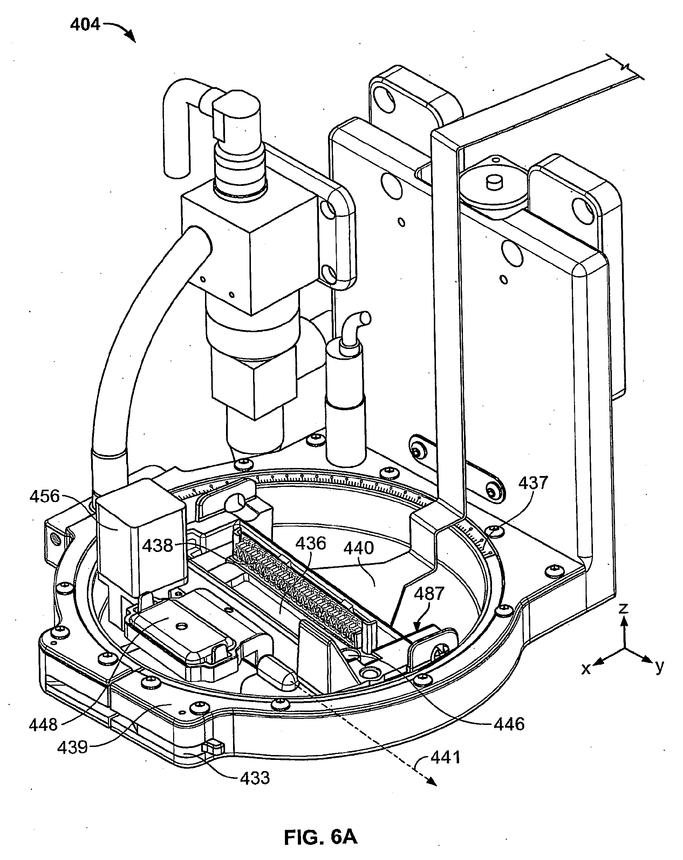

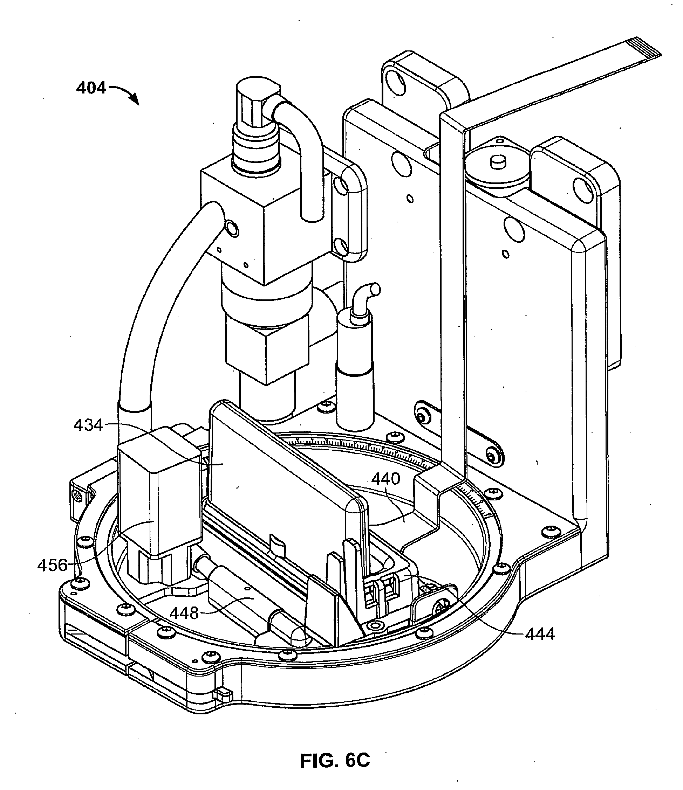

FIGS. 6A-C show enlarged views of the cartridge mount assembly 404. In this implementation, the cartridge mount assembly 404 is configured to mount a single-use print cartridge 434 shown in FIG. 6C. For example, the single-use print module described in U.S. Patent Application No. 11/305,824, entitled "Single-Use Droplet Ejection Module", filed December 16, 2005, by Bibl *et al,* the entire contents of which are hereby incorporated herein by reference, can be mounted in the cartridge mount assembly 404, although differently configured print-cartridges (whether single-use or reusable) can also be used.

Referring particularly to FIG. 6A, the cartridge mount assembly 404 is shown without the print cartridge 434 mounted therein. The cartridge mount assembly 404 includes a receptacle 436 configured to receive the print cartridge 434. The receptacle 436 includes a number of electrical contacts 438 that are configured and positioned to mate with corresponding electrical contacts included on the print cartridge 434. When the print cartridge 434 is mounted within the receptacle 436, the electrical contacts 438 in the receptacle mate with the corresponding electrical contacts on the print cartridge 434, providing a pathway for electrical signals from the cartridge mounting assembly 104 to the print cartridge 434. The electrical contacts 438 included in the receptacle 436 are electrically connected to a flexible circuit 440 that can be connected directly or indirectly to a processor (e.g., processor 420, FIG. 4B) providing signals to fire the one or more nozzles included in the print cartridge 434.

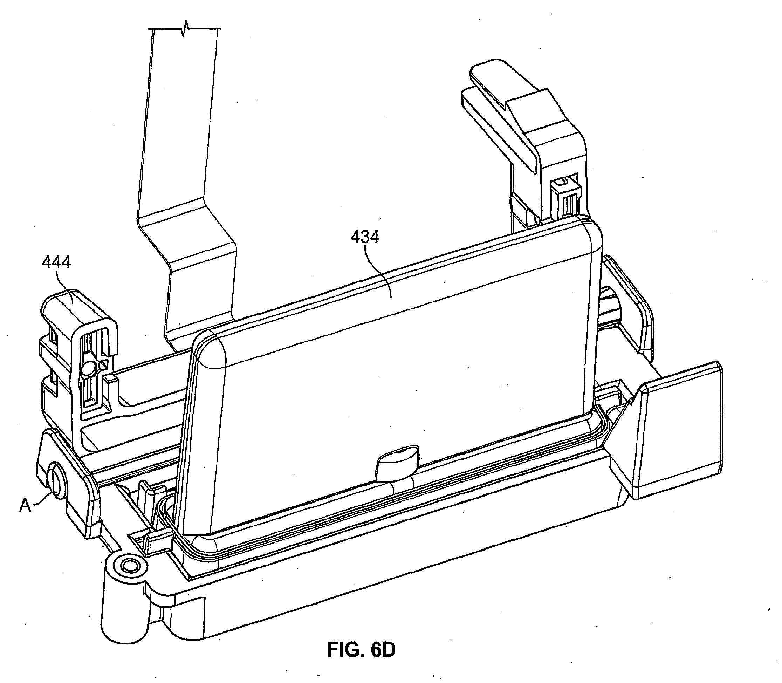

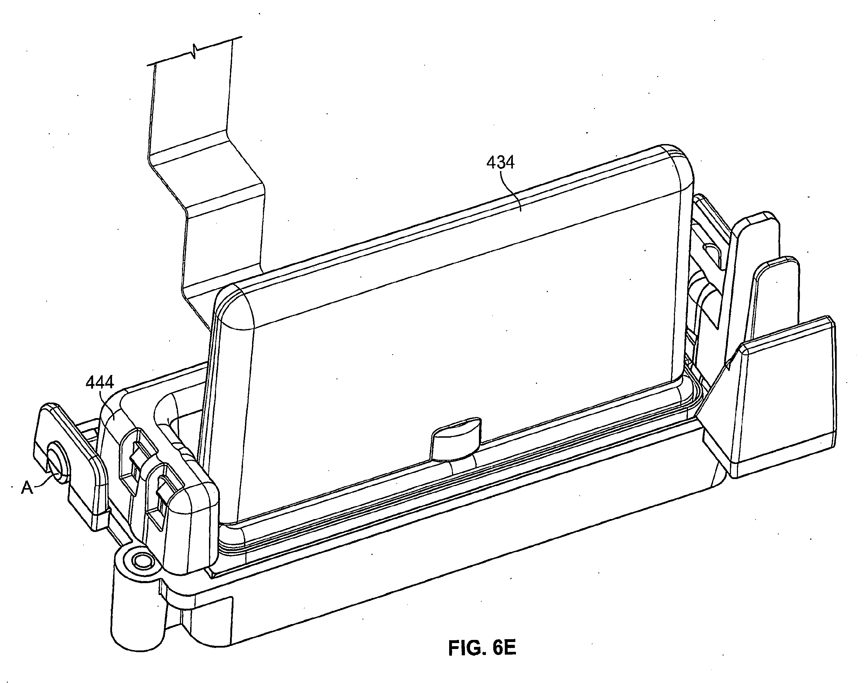

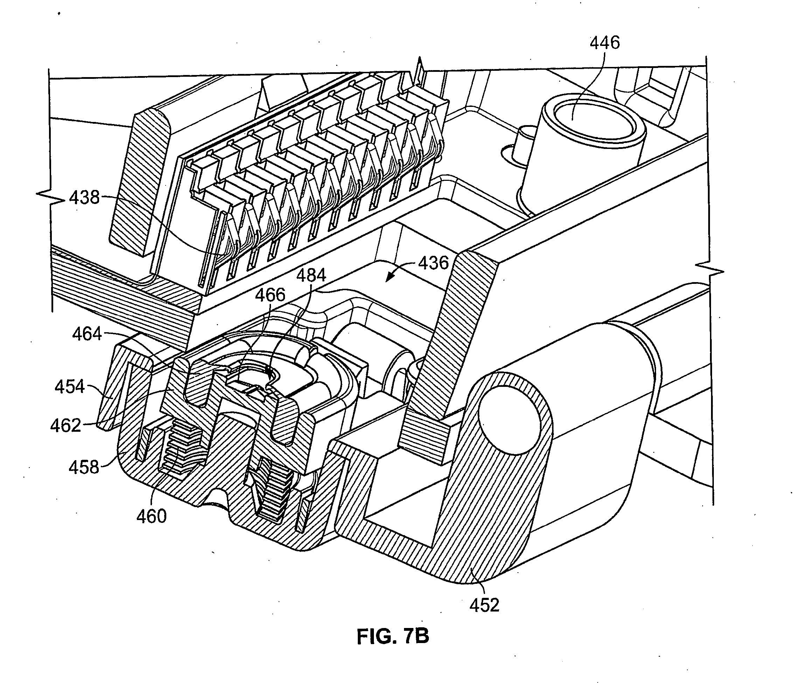

The electrical contacts 438 can be formed from a resilient, conductive material. Referring to FIG. 7B, an enlarged cross-sectional view of a portion of the cartridge mount assembly 404 is shown, including an enlarged view of the electrical contacts 438. Referring again to FIG. 3C, the print cartridge 434 is shown mounted in place within the receptacle 436. Once the print cartridge 434 is positioned in place, a pivoting latch 444 can be rotated into a locking position to secure the print cartridge 434 in place within the receptacle 436. For illustrative purposes, the latch 444 is not shown in FIG. 6A, so as not to obscure other features. Referring to FIGS. 6D and 6E, a partial view of the cartridge mount assembly 404 is shown to illustrate the latch 444. In FIG. 6D, the latch 444 is shown open and in FIG. 6E the latch 444 is shown in the closed position. The latch 444 pivots about point A and can be held shut by a snap-fit connection or any other convenient connection.

Referring again to FIG. 6A, a vacuum connector 446 is shown positioned at an end of the receptacle 436. An enlarged view of the vacuum connector 446 is shown in FIG. 4B. The vacuum connector 446 is in communication with a vacuum source. In one implementation, the vacuum source is connected by a tube to a vacuum inlet positioned on the cartridge mount assembly 404 at approximately location 487 (FIG. 6A). The vacuum inlet is fluid coupled to the vacuum connector 446.

The relative positions of the electrical contacts 438 on the receptacle and the corresponding electrical contacts on the print cartridge 434, in conjunction with the relative positions of the vacuum connector 446 on the receptacle and the corresponding vacuum inlet on the print cartridge 434, are such that when the print cartridge 434 is inserted into the receptacle 436 the electrical connection between the electrical contacts 438 and corresponding contacts on the print cartridge 434, and the connection between the vacuum connector 446 and a corresponding vacuum inlet on the print cartridge 434, are formed at substantially the same time. The vacuum source can thereby provide a vacuum within the print cartridge's housing, providing back pressure to maintain a meniscus pressure at the nozzles and prevent leakage. By a single step of positioning the print cartridge 434 into place in the receptacle 436, a user can make both of these connections at substantially the same time.

Referring again to FIG. 6A, a cap 448 is included in the cartridge mount assembly 404. The cap 448 is pivotable about an axis 441. The cap 448 can be used to cap the nozzles included in the print cartridge 434 when the print cartridge 434 is not engaged in a print operation. Capping the print cartridge 434 can be important to reduce or eliminate evaporation of the fluid from the print cartridge 434, and to prevent leakage. During a print operation or when there is no desire to cap the print cartridge 434, the cap can remain in the "open" position shown in FIG. 6A. When there is a need to cap the print cartridge 434, the cap pivots about the axis 441 approximately 180° into the "closed" position shown in FIG. 6C.

Generally, during a print operation the cartridge mount assembly 404 is positioned relatively close to the substrate mounted on the platen 402. The distance between the nozzles included in the print cartridge 434 and the substrate can be referred to as the "flight height". The cartridge mount assembly 404 can be moved up and down vertically in the z-direction to adjust the flight height, or to adjust for changes in thickness of the substrate. In one implementation, a user can enter the substrate thickness into a user interface and the cartridge mount assembly 404 adjusts in the z-direction accordingly. Alternatively, the user can be presented with a high and a low flight height appropriate for the indicated substrate thickness, and the user can select the flight height. In another alternative, the user can input a specific flight height, and the cartridge mount assembly 404 adjusts accordingly.

Additionally, the cartridge mount assembly 404 can be moved upwardly in the z-direction a sufficient distance to provide clearance for the cap 448 to pivot about axis 441 into the closed position. In one implementation, when the cartridge mount assembly 404 receives an instruction to cap the print cartridge 434, either manually or automatically through the flexible circuit 440 connected to a processor (*e.g*., processor 420), the cartridge mount assembly 404 automatically moves upwardly in the z-direction a predetermined distance, pivots the cap 448 from the open to the closed position, and either lowers to the original position, or awaits further instructions. Because the cartridge mount assembly 404 would need to move the cap into the open position to resume the print operation, it can be more efficient to maintain the higher position, until receiving an instruction to switch the cap back into the open position.

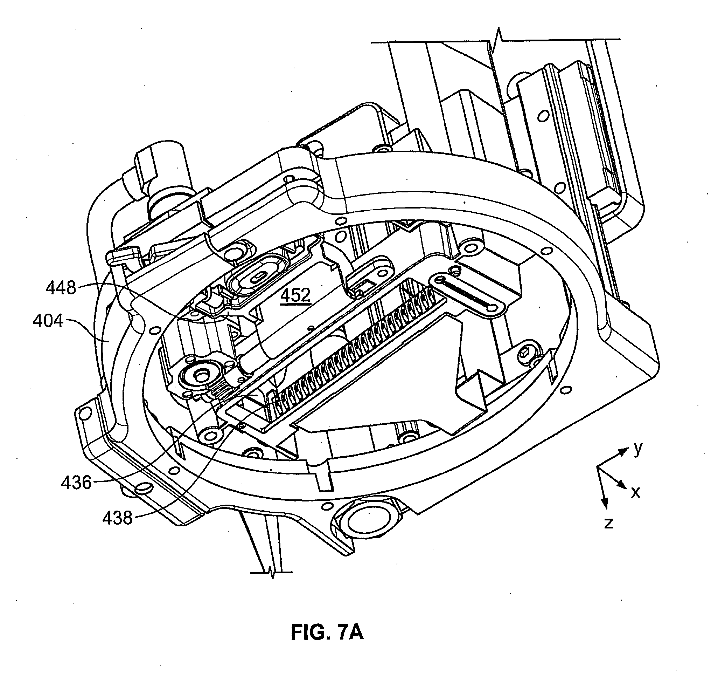

Referring to FIGS. 7A and 7B, the cap 448 is shown in more detail. FIG. 7A shows the underside of the cartridge mount assembly 404 with the bottom panel 493 (shown in FIGS. 6A-C) removed to provide a better view of the cap 448, shown in the open position. FIG. 7B shows an enlarged cross-sectional view of a portion of the cartridge mount assembly 404, with the cap 448 in the closed position. The cap 448 includes pivot arm 452 configured to pivot the cap 448 between the open and closed positions. The pivot arm 452 is attached to an outer housing 454 that extends the perimeter of the cap 448. A motor 456 drives the pivot arm 452 between the open and closed positions. The motor 456 can be electrically connected to the flexible circuit 440 to receive instructions from a processor (*e.g*., processor 420) coupled to the flexible circuit 440 and/or from a user interface coupled to the flexible circuit 440.

A center portion 458 of the cap 448 is attached to the outer housing 454 and includes a recess within which a spring member 460 is positioned. The spring member 460 contacts a seal housing 462 and when the cap 448 is in the closed position, the spring member 460 urges the seal housing 462 and seal 464 positioned therein, into contact with the nozzle face of the print cartridge 434. The seal 464 is positioned within a groove formed in the seal housing 462 and is formed from a compressible material, *e.g*., an elastomer compatible with the printing fluid. The lip 484 formed in the upper surface of the seal 464 can be configured to form a liquid-tight seal around the region on the nozzle face of the print cartridge 434 that includes the nozzles. A cavity 466 is formed in the seal housing 462. The cavity 466 is relatively small, and can quickly become saturated with the fluid contained in the print cartridge 434. Once saturated, equilibrium is reached, and no more evaporation of the fluid from the print cartridge 434 will occur. Accordingly, the amount of fluid lost due to evaporation during downtime (*i.e.,* when not printing) can be minimized.

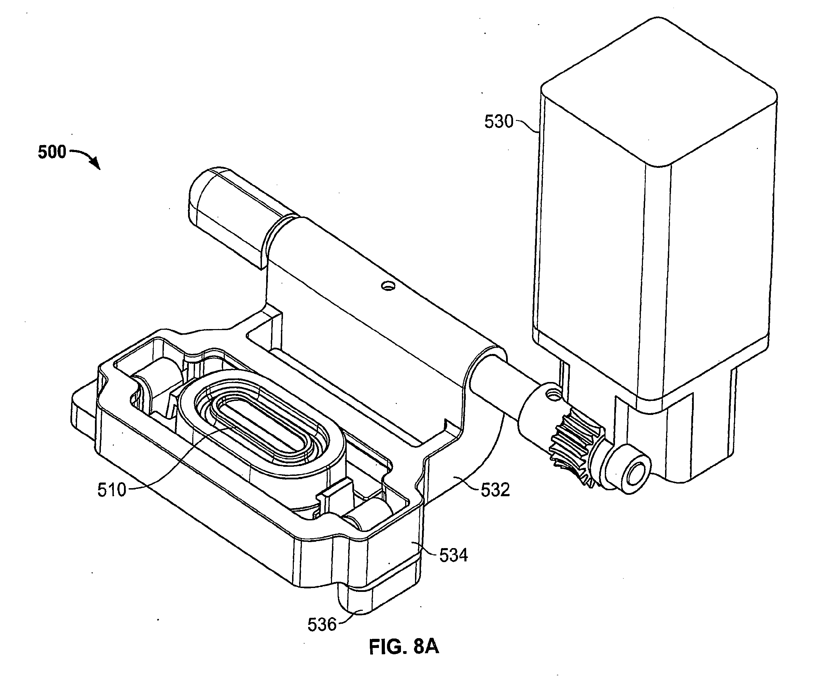

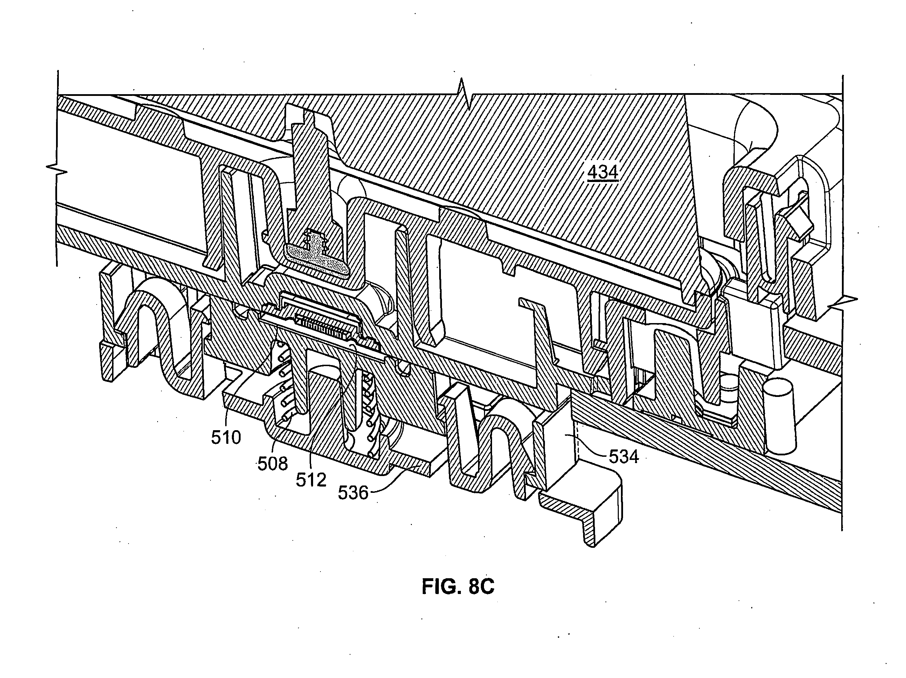

Referring to FIGS. 8A-C, an alternative embodiment of a cap 500 is shown. This implementation of the cap 500 is suitable for applications where the nozzles need to continue to fire while the cap 500 is in the closed position, *e.g*., to maintain the desired viscosity of the print fluid at the nozzles. The cap 500 includes pivot arm 532 configured to pivot the cap 500 between the open and closed positions. The pivot arm 532 is attached to an outer housing 534. A motor 530 drives the pivot arm 532 between the open and closed positions. The motor 530 can be electrically connected to the flexible circuit 440 to receive instructions from a processor coupled to the flexible circuit 440 and/or from a user interface coupled to the flexible circuit 440.

A center portion 536 of the cap 500 is attached to the outer housing 534 and includes a recess within which a spring member 508 is positioned. The spring member 508 contacts a porous member 510 and when the cap 500 is in the closed position, the spring member 508 urges the porous member 510 at least partially into contact with the nozzle face of the print cartridge 434. The porous member can be substantially rigid and is formed from a porous material configured to absorb fluid deposited on the porous member 510 while the cap 500 is in the closed position and the nozzles are continuing to fire. In one implementation, the porous member 510 is made from a porous polymer known as XM1538 UHMWPE (UltraHigh Molecular Weight PolyEthylene) having an approximate pore size of 90-110 microns, available from Porex.

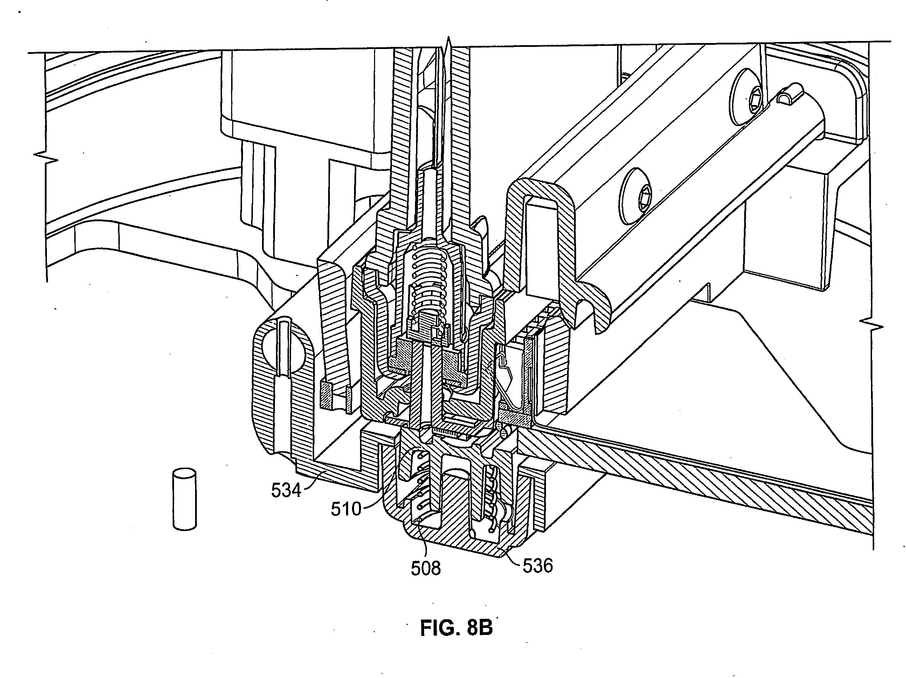

Referring particularly to FIG. 8B, the cap 500 is shown in a closed position against the nozzle face of a print cartridge 434. The porous member 510 is configured to collect and absorb fluid deposited on the porous member 510 by the nozzles while the cap 500 is closed. FIG. 5C shows a longitudinal, cross-sectional view of the cap 500 in the closed position against the print cartridge 434. A gap 512 is provided between the nozzles on the print cartridge 434 and the porous member 510 to provide clearance for the fluid to eject from the nozzles and collect on the porous member 510.

In one implementation, the cap 448 or 500 is driven into the closed position by a motor 456 or 530 having a worm gear drive (see FIG. 8A). The motor has a relatively large mechanical advantage and cannot be back driven. The motor drives the cap 448 rotationally until the cap 448 contacts the print cartridge 434 and then stops. Until the motor is instructed (*e.g*., by processor 420) to drive the cap 448 in the opposite direction to pivot the cap 448 into the open position, the cap 448 is held in the closed position by the motor.

Referring again to FIG. 5, the platen 402 can be configured to rotate about the z-axis to square the substrate relative to the print cartridge 434. For example, a camera included in the fluid deposition device 307 can be used to detect an edge of the substrate. A processor (*e.g*., processor 420) coupled to the camera can determine the position of the substrate relative to the cartridge mount assembly 404. The processor can provide instructions, based on the determined position, to the motor coupled to the platen 402 to rotate the platen 402 accordingly to square the substrate relative to the cartridge mount assembly 404, and therefore relative to the print cartridge 434 therein.

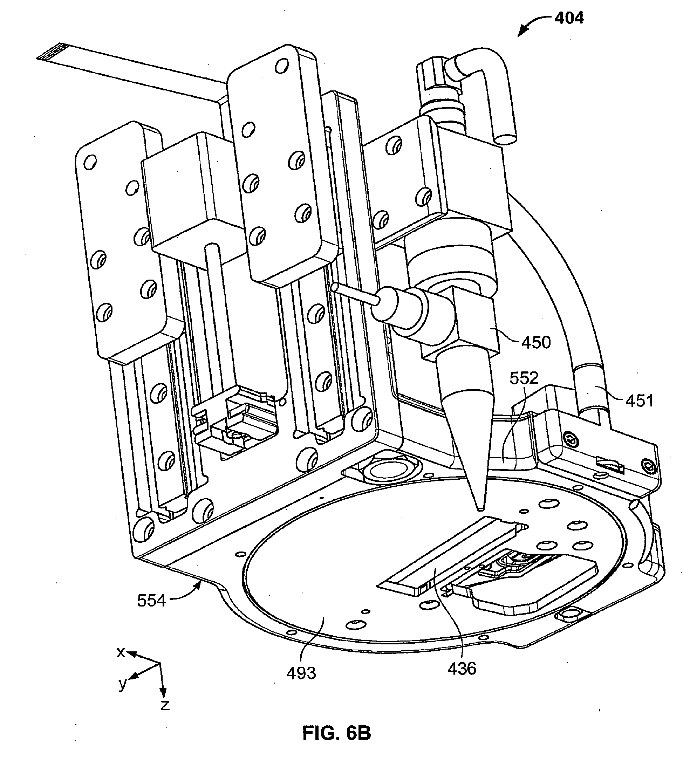

In another implementation, the camera can look for fiducials (*i.e*., registration marks) on the substrate and align the substrate relative to the cartridge mount assembly 404 accordingly. In another implementation, the substrate can be aligned using the fiducials and a set of test dots can be printed onto the substrate. The camera can look at the print dots and determine their position relative the fiducials and re-align the substrate accordingly. Referring to FIG. 6B, one example of a camera 450 is shown. The camera 450 is attached to, and moves with, the cartridge mount assembly 404, making the capping feature significant, as the print cartridge 434 can remain capped while the cartridge mount assembly 404 traverses the substrate searching for fiducials, etc. The camera 450 can be electrically coupled, for example through the flexible circuit 440, to the processor 420 shown in FIG. 4B.

Referring again to FIG. 6B, in one implementation the cartridge mount assembly 404 includes an ultraviolet light wand 451. The ultraviolet light wand 451 is useful for applications involving a printing fluid that must be immediately cured by ultraviolet light. The ultraviolet light wand 451 is mounted on the trailing edge 552 of the cartridge mount assembly 404, as opposed to the leading edge 554. In this implementation, a print operation only occurs when the cartridge mount assembly 404 is moving such that the leading edge 554 leads when traversing the substrate. The ultraviolet light wand 451 therefore trails and cures the printing fluid while passing over the fluid immediately after deposition onto the substrate. During the return stroke across the substrate, i.e., when the trailing edge 552 leads, the printing operation temporarily ceases. In one implementation the cap 448 can seal the nozzles during the return stroke.

Referring again to FIG. 5, a drop watcher camera system 480 is mounted to one side of the platen 402. The camera system 480 allows a user to watch fluid drops as they exit the print cartridge 434 and are printed on a test pad positioned in front of the camera system 480. A strobed light source strobes light at a speed approximately equal to the speed of the drops being fired from the nozzles. By strobing the light slightly out of phase with the nozzle firing, a series of pictures of a series of fluid drops in flight between the nozzle and the test pad can be obtained. A composite of the series of pictures viewed together can give the illusion of a video clip of a single drop being ejected from a nozzle: in reality, the "video" is actually a composite of a series of still pictures taken of many different drops at slightly different stages of formation and flight.

In one implementation, the display 430 can be used to provide a graphical display to the user of the drops as captured by the camera system 480. Simultaneously, for example, using a split screen or multiple frames within a screen, a graphical representation of a waveform corresponding to the drive pulse to an actuator included in the print cartridge 434 to fire the nozzles can be displayed. The user can view the fluid drops and waveform and make adjustments as desired using the user input device 425. For example, the user can adjust the drive voltage delivered to the printhead within the print cartridge 434, duration of the voltage pulse, slope of the waveform, number of pulses, and other adjustable parameters. The user input is used by the processor 420, *e.g*., by a software application executing in the processor, to adjust the signals sent to the actuator or actuators located within the print cartridge 434.

Referring again to FIG. 6A, a calibrated guide 437 can be included on the cartridge mount assembly 404. A user can move latch cam 433 from the closed position shown to an open position. In the open position, the frame 439 of the lower portion of the cartridge mount assembly 404 is slightly released, and the components of the cartridge mount assembly 404 included within the perimeter formed by the calibrated guide 437 are rotatable about the z-axis. By rotating components of the cartridge mount assembly 404, including the receptacle 436 and therefore the position of a print cartridge 434 mounted therein, the print resolution can be adjusted. For example, consider a print cartridge 434 including a single row of nozzles arranged along the length of the print cartridge 434 in the x-direction. At zero rotation of the print cartridge 434, dots printed from the nozzles form a line in the x-direction. When rotated a few degrees, the dots can be printed closer to one another, and depending on the desired resolution, the angle of rotation of the print cartridge 434 relative to the cartridge mount assembly frame 439 can be adjusted. In one implementation, a Vernier scale is used to scale the calibrated guide 437, although other scales can be used.

In one implementation, the drop watcher camera system 480 can be used to determine the actual angle of the print nozzles as set by the user using the calibrated guide 437. The drop watcher camera system 480 can find coordinates of a position of a first nozzle and coordinates of a position of a second nozzle a known distance from the first nozzle. The processor 420, coupled to the drop watcher camera system 480, can thereby calculate the offset angle of the nozzles relative to one another. Knowing the actual angle, as compared to the angle the user believes he/she set the calibrated guide 437 to is significant, as the timing of dot placement can be dependent on the offset angle. Therefore, the more accurate the offset angle, the more accurate the timing delays when firing the nozzles, thereby improving the printing accuracy. The processor 420 (*i.e.,* a software application executing in the processor) can use the actual angle to adjust the operating parameters, *e.g*., the drive signals to the print cartridge 434.

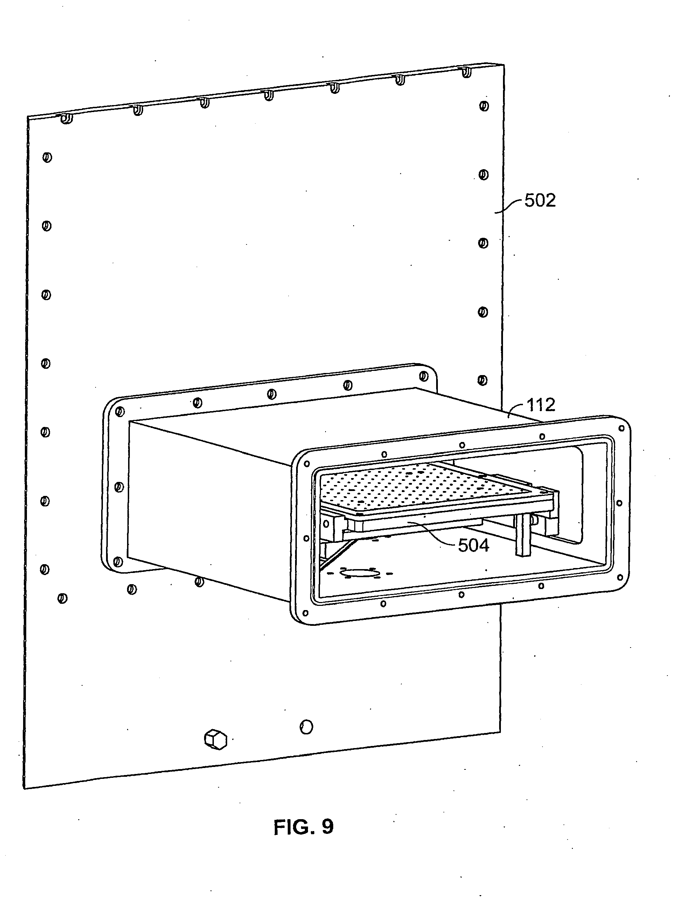

FIG. 9 shows an expanded view of the low temperature cure chamber 112 according to one implementation. The low temperature cure chamber 112 is configured to perform a low temperature cure operation on a substrate after fluid has been deposited on the substrate in the fluid deposition chamber 108. In one implementation, performing a low temperature cure operation on a substrate includes heating the substrate at relatively low temperature for a predetermined amount of time. It should be understood that the cure time and temperatures can vary depending on the process (*i.e*., the fluid, substrate, etc.). The low temperature cure chamber 112 is connected to a panel 502 that attaches to the main chamber 102. The low temperature cure chamber 112 includes an opening (not shown) at the interface between the low temperature cure chamber 112 and the main chamber 102, through which the robot 104 can transfer substrates between the two chambers. A door seals the low temperature cure chamber 112 from the main chamber 102, so that the heat from the low temperature cure operation does not substantially affect the temperature within the main chamber 102.

For illustrative purposes, the low temperature cure chamber 112 shown in FIG. 9 is shown with one of its exterior panels removed to reveal the interior of the chamber 112. However, it should be understood that the low temperature cure chamber 112 is an enclosed chamber. The low temperature cure chamber 112 includes a platen 504 including multiple, retracting pins. The pins are in an extended position when the substrate is positioned within the low temperature cure chamber 112, thereby providing clearance between the lower surface of the substrate and the upper surface of the platen 504 for the robot's arm. Once the robot's arm is retracted from the low temperature cure chamber 112, the pins retract flush with the platen 504, and the substrate rests on the platen 504. Optionally, the platen 504 can be configured to vacuum chuck the substrate to the surface of the platen 504 during the low temperature cure operation.

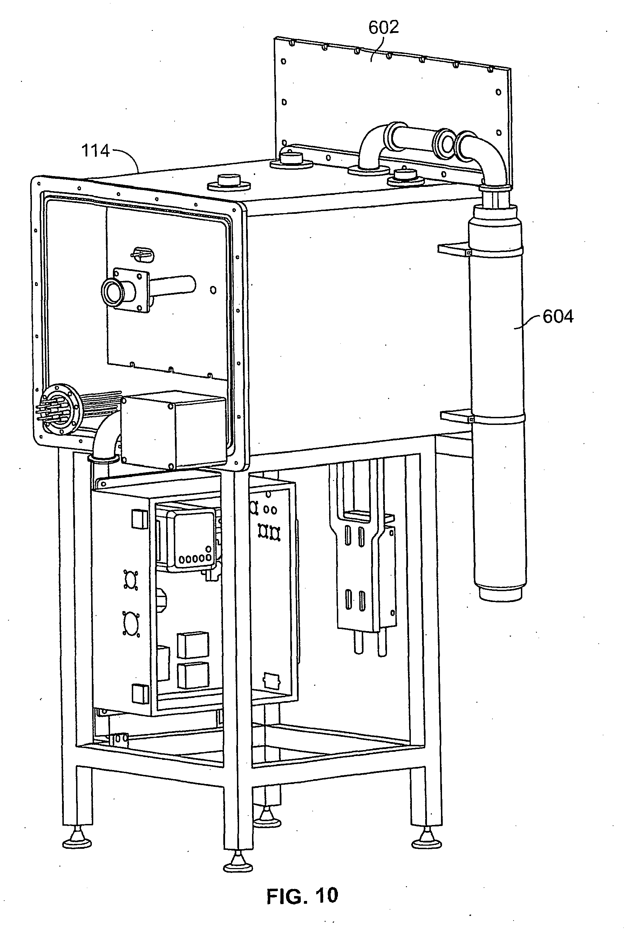

Referring now to FIG. 10, the high temperature cure chamber 114 is configured to perform a high temperature cure operation on a substrate, typically after the low temperature cure operation has been performed. In one implementation, performing a high temperature cure operation on a substrate includes heating the substrate at a relatively high temperature, *e.g*., several hundred degrees Celsius for a predetermined amount of time. It should be understood that the cure time and temperatures can vary depending on the process (*i.e*., the fluid, substrate, etc.). A perspective, back view of the high temperature cure chamber 112 according to one implementation is shown. A rear exterior panel is removed for illustrative purposes to reveal some interior components of the high temperature cure chamber 114. The high temperature cure chamber 114 is connected to a panel 602 that attaches to the main chamber 102. The high temperature cure chamber 114 includes an opening (not shown) at the interface with the main chamber 102 through which the robot 104 can transfer substrates between the main chamber 102 and the high temperature cure chamber 114. A door is included at the interface to isolate the high temperature cure chamber 114 during a high temperature cure operation, such that temperatures within the high temperature cure chamber 114 do not substantially affect the environment within the main chamber 102. The high temperature cure chamber 114 can include a heat exchanger 604 to reduce the gas temperature recirculating out of the high temperature cure chamber 114 prior to circulating it through the gas purification system.

In one implementation, the interior of the high temperature cure chamber 114 is lined with quartz to help maintain a clean environment. The substrate can be placed on a quartz boat that includes posts (*e.g*., 16 posts) standing up so that the substrate rests on upper surfaces of the posts, facilitating handling by the robot 104. The high temperature cure chamber 114 can also include a port that allows the chamber 114 to be filled with an alternate gas composition (*i.e.*, different than the balance of the cluster tool 100). The port can be plumbed to the high temperature cure chamber 114 by a tube (e.g., stainless steel tube) that penetrates the back wall of the high temperature cure chamber 114 and couples to the quartz liner.

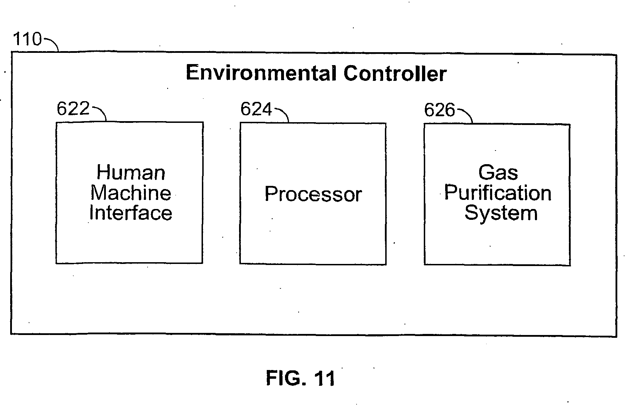

FIG. 11 shows a schematic representation of the environmental controller 110 included in the fluid deposition cluster tool 100 according to one implementation. In one implementation, the environmental controller 110 includes a gas purification system 626 for controlling the gas composition inside the chambers included in the fluid deposition cluster tool 100. In one implementation, the gas purification system 626 maintains a substantially pure nitrogen environment inside the chambers included in the fluid deposition cluster tool 100 by substantially removing oxygen and moisture from air included in the chambers leaving only nitrogen behind. In one implementation, a molecular sieve is used to remove the moisture and oxygen. An exemplary gas purification system that can be used is the Nexus Dri-Train inert gas purification system available from Vacuum Atmospheres Company, a division of WEMS, Inc., doing business in Hawthorne, California.

The gas within the fluid deposition cluster tool 100 can be constantly recirculated through the cluster tool 100 and through the gas purification system 626. As it may take days to fully equilibrate the environment within the fluid deposition cluster tool 100, every attempt to maintain the environment free from contamination are made. It may be necessary in some instances to remove contaminated gas from the fluid deposition chamber 108 directly and vent it out of the gas purification system 626 rather than attempt to recirculate it. For example, if a fluid deposition operation introduces excess moisture into the environment and/or to prevent high concentrations of potentially dangerous or harmful gases from accumulating within the fluid deposition cluster tool 100.

The environmental controller 110 can further include a processor 624 configured to provide control signals to the gas purification system 626. The processor 624 can be the same as processor 420, which controls elements within the chambers included in the fluid deposition device 307, or be a separate processor. The environmental controller 110 can further include a human machine interface 622 to provide for interaction with a human operator. The human operator can use the human machine interface 622 to send instructions to the processor 624, *e.g.,* to change operating conditions and/or parameters. To provide for interaction with a human operator, the human-interaction interface 622 can be implemented on a computer system having a display device such as a monitor or LCD screen or display 430 for displaying information to the human operator and a keyboard and a pointing device such as a mouse or a trackball, which can include user input device 425, by which the human operator can provide input to the computer system. The computer system can be programmed to provide a graphical user interface through which computer programs interact with users. Other forms of human machine interface 622 can be used, and the above description is meant to be exemplary.

In another implementation, the fluid deposition cluster tool 100 includes a second processor to control the robot 104 and/or to other functioning elements within the fluid deposition cluster tool 100. For example, the processor 624 can provide control signals to the fluid deposition cluster tool 100 to control a fluid deposition operation, and can provide control signals to the low temperature and high temperature cure chambers 112, 114 to control the duration and temperature of the cure operations. Likewise, the processor can provide control signals to the robot 104 to transfer substrates between the different chambers included in the fluid deposition cluster tool 100, and control signals to the various doors between the chambers and the main chamber 102, to open and close when required. The fluid deposition device 307 can also be controlled by the processor, for example, fire signals to nozzles included in a print cartridge within the fluid deposition device 307. In one implementation, a single processor can perform the functions of the said processor and the processor 624 included in the environmental controller 110. In the implementation where the fluid deposition device 307 is the embodiment described above in reference to FIGS. 4A-8C, the single processor optionally can also perform the functions of the processor 420 described above in reference to said fluid deposition device.

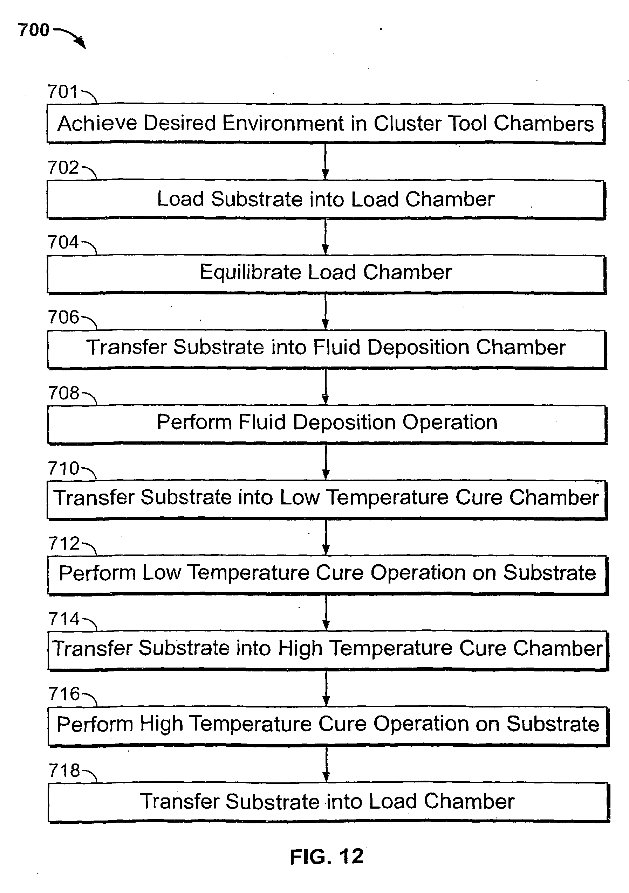

Referring now to FIG. 12, one example of a process 700 for processing a substrate using the fluid deposition cluster tool 100 is shown. For simplicity, a single substrate is processed in this example. However, it should be understood that the process 700 described in reference to FIG. 12 can be applied to use the fluid deposition cluster tool 100 to process multiple substrates simultaneously.

In a first step, the desired environmental conditions within the fluid deposition cluster tool 100 are achieved (step 701). For example, as referred to above, in one implementation. Accordingly, the desired environmental conditions include the removal of all oxygen from the atmosphere, as well as all moisture, leaving substantially pure nitrogen. The gas purification system 626 included in the environmental controller 110 is used to achieve the desired gaseous state, and the gas within the fluid deposition cluster tool 100 is continuously recirculated through the cluster tool 100 and through the gas purification system 626 to maintain the desired state.

Once the desired environmental conditions within the fluid deposition cluster tool have been achieved, the exterior door 206 of the load chamber 106 is opened and a substrate is loaded into the load chamber (or a cassette filled with one or more substrates is loaded into the chamber) (step 702), *e.g.,* by a human operator. Alternatively, a second robot located outside of the fluid deposition cluster tool 100 can be used to load and unload the load chamber 106 through the exterior door 206. Thereafter, the exterior door 206 of the load chamber 106 is closed.

Because the exterior door 205 of the load chamber 106 is opened to load the substrate, the environment within the load chamber 106 is contaminated by the exterior environmental conditions. Therefore, the load chamber 106 is equilibrated to the environment of the main chamber 102 before further processing of the substrate takes place (step 704). For example, as described above, a vacuum source can be directly connected from the gas purification system 626 to the load chamber 106 to remove contaminated gas relatively quickly from just the load chamber 106.

Once the load chamber 106 is equilibrated to the environment of the main chamber 102, the interior door of the load chamber opens (either automatically or using the robot 104), and the robot 104 transfers the substrate from the load chamber 106 into the main chamber 102 and next into the fluid deposition chamber 108 (step 706). If the optional interior door is included at the fluid deposition chamber/main chamber interface, then the interior door closes and seals the fluid deposition chamber 108. Inside the fluid deposition chamber 108, a fluid deposition operation is performed on the substrate using the fluid deposition device (step 708).

Once the fluid deposition operation is completed, the robot 104 transfers the substrate from the fluid deposition chamber 108 into the main chamber 102 and into the low temperature cure chamber 112 (step 710). The robot 104 places the substrate on the extended pins on the platen 402 inside the low temperature cure chamber 112, the robot arm retracts and the pins retract. The interior door to the low temperature cure chamber 112 closes sealing the low temperature cure chamber 112 from the main chamber 102. Once the substrate is resting on the platen 402, the substrate is vacuum chucked and the low temperature cure operation is performed (step 712).

After the low temperature cure operation is completed, the robot 104 transfers the substrate from the low temperature cure chamber 112 into the high temperature cure chamber 114 (step 714). Again, the interior thermal door (or doors) to the high temperature cure chamber 114 is closed once the substrate has been placed inside, to isolate the environment in the main chamber 102 from the higher temperatures inside the high temperature cure chamber 114. Inside the high temperature cure chamber, the high temperature cure operation is performed (step 716). Thereafter, the robot 104 transfers the substrate from the high temperature cure chamber 114 into the load chamber 106 (step 718). A human operator or second robot can unload the processed substrate from the load chamber 106.

The fluid deposition cluster tool 100 described above and shown in FIGS. 1A-C is one embodiment of the fluid deposition cluster tool 100. Other configurations are possible, including a fluid deposition cluster tool 100 including one or more additional fluid deposition chambers 108, for example, for a printing operation requiring serial or layered printing. The main chamber 102 can have different configurations, including more or fewer faces, and a different shape. The chambers coupled to the main chamber 102 can be arranged in a vertical configuration relative to one another, or in a both vertical and horizontal configuration. One or more additional robots can be included in the main chamber 102. The environmental conditions within different chambers within the fluid deposition cluster tool 100 can be different, and can be coupled to one or more additional gas purification systems 626 and temperature controls. The fluid deposition cluster tool 100 can include no low temperature and high temperature cure chambers, or additional low temperature and/or high temperature cure chambers. The temperatures within the low temperature and high temperature cure chambers and cure times can be different than those described in the above example.

The use of terminology such as "front" and "back", "top" and "bottom", and "upper" and "lower", throughout the specification and claims is for illustrative purposes only, to distinguish between various components of the fluid deposition cluster tool 100 and other elements described herein. For example, the use of "upper" and "lower" does not imply a particular orientation of the fluid deposition cluster tool 100 or the components included in the fluid deposition cluster tool 100.

The fluid deposition cluster tool 100 has been described above for illustrative purposes in relation to a fluid deposition process requiring a dry, oxygen-free environment of substantially pure nitrogen. However, other environments are possible, for example, inert, oxidizing, low Rh, high Rh, and various others. The environmental conditions described are meant to be illustrative only.

Elements of the fluid deposition cluster tool 100, including but not limited to, the environmental controller 110, and at least some of the functional operations described in this specification can be implemented in digital electronic circuitry, or in computer software, firmware, or hardware, including the structural means disclosed in this specification and structural equivalents thereof, or in combinations of them. Elements of the fluid deposition cluster tool 100, including but not limited to, the environmental controller 110, can be implemented as one or more computer program products, *i.e.,* one or more computer programs tangibly embodied in an information carrier, *e.g.,* in a machine-readable storage device or in a propagated signal, for execution by, or to control the operation of, data processing apparatus, *e.g*., a programmable processor, a computer, or multiple processors or computers. A computer program (also known as a program, software, software application, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file. A program can be stored in a portion of a file that holds other programs or data, in a single file dedicated to the program in question, or in multiple coordinated files (*e.g*., files that store one or more modules, sub-programs, or portions of code). A computer program can be deployed to be executed on one computer or on multiple computers at one site or distributed across multiple sites and interconnected by a communication network.

The processes and logic flows described in this specification, including the method steps of the invention, can be performed using one or more programmable processors executing one or more computer programs to perform functions of the invention by operating on input data and generating output. The processes and logic flows can also be performed by, and apparatus of the invention can be implemented as, special purpose logic circuitry, e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions and one or more memory devices for storing instructions and data. Generally, a computer will also include, or be operatively coupled to receive data from or transfer data to, or both, one or more mass storage devices for storing data, *e.g.,* magnetic, magneto-optical disks, or optical disks. However, a computer need not have such devices. Moreover, a computer can be embedded in another device, *e.g.,* a mobile telephone, a personal digital assistant (PDA), a mobile audio player, a Global Positioning System (GPS) receiver, to name just a few. Information carriers suitable for embodying computer program instructions and data include all forms of non-volatile memory, including by way of example semiconductor memory devices, *e.g.,* EPROM, EEPROM, and flash memory devices; magnetic disks, *e.g.,* internal hard disks or removable disks; magneto-optical disks; and CD-ROM and DVD-ROM disks. The processor and the memory can be supplemented by, or incorporated in, special purpose logic circuitry.

To provide for interaction with a user, the invention can be implemented including a computer having a display device, *e.g.,* a CRT (cathode ray tube) or LCD (liquid crystal display) monitor, for displaying information to the user and a keyboard and a pointing device, *e.g.,* a mouse or a trackball, by which the user can provide input to the computer. Other kinds of devices can be used to provide for interaction with a user as well; for example, feedback provided to the user can be any form of sensory feedback, *e.g.,* visual feedback, auditory feedback, or tactile feedback; and input from the user can be received in any form, including acoustic, speech, or tactile input.

A number of embodiments of the invention have been described. Nevertheless, it will be understood that various modifications may be made without departing from the scope of the invention as defined by the claims. The steps described in the flowchart shown in FIG. 12 can be performed in a different order than shown and still achieve the desired results.

## Claims

1. A cluster tool (100) comprising:
a main chamber (102);
a load chamber (106) coupled to the main chamber (102) and configured to receive one or more substrates;
a fluid deposition chamber (108) coupled to the main chamber (102), the fluid deposition chamber (108) including an inkjet printer fluid deposition device (307) configured to deposit fluid onto the one or more substrates;
a robot (104) included in the main chamber (102), the robot (104) configured to transfer the one or more substrates between the load chamber (106) and the fluid deposition chamber (108); and
an environmental controller (110) configured to maintain a substantially autonomous environment within the cluster tool including the main, the load, and the fluid deposition chambers, the autonomous environment permitting fluid deposition operations to occur under controlled conditions.

2. The cluster tool (100) of claim 1 further comprising:
a low temperature cure chamber (112) coupled to the main chamber and configured to perform a low temperature cure operation on the one or more substrates; and
a high temperature cure chamber (114) coupled to the main chamber and configured to perform a high temperature cure operation on the one or more substrates.

3. The cluster tool (100) of any preceding claim, wherein the load chamber (106) includes an interior door coupled to the main chamber (102) and one or more exterior faces, wherein the load chamber (106) is configured to receive the one or more substrates through an exterior door in at least one of the one or more exterior faces.

4. The cluster tool (100) of any preceding claim, wherein the fluid deposition chamber (108) includes an interior opening coupled to the main chamber and one or more exterior faces, the opening lacking an interior door.

5. The cluster tool (100) of any preceding claim, wherein the fluid deposition chamber (108) includes a rapid transfer port.

6. The cluster tool (100) of any preceding claim, wherein the fluid deposition chamber (108) includes one or more gloves sealed to one or more of the exterior faces and extending into the fluid deposition chamber (108).

7. The cluster tool (100) of any preceding claim, wherein the environmental controller (110) includes a gas purification system (626) configured to control a gas composition inside the chambers included in the cluster tool (100).

8. The cluster tool (100) of claim 7, where the enviromnental controller (110) further includes a processor (624, 420) configured to provide control signals to the gas purification system (626) to control the gas composition included within the chambers of the cluster tool (100).

9. The cluster tool (100) of either claim 7 or 8, wherein controlling the gas composition inside the chambers included in the cluster tool (100) comprises controlling a level of moisture inside the chambers included in the cluster tool (100).

10. The cluster tool (100) of any one of claims 7, 8, or 9, wherein the gas within the cluster tool (100) is constantly recirculated through the cluster tool (100) and through the gas purification system (626).

11. The cluster tool (100) of any preceding claim further comprising a processor configured to provide control signals to the robot (104).

12. The cluster tool (100) of claim 11, where the processor is further configured to provide control signals to one or more of the chambers coupled to the main chamber included in the cluster tool (100).

13. The cluster tool (100) of any preceding claim, further comprising:
a human machine interface (622) configured to receive user input to control the cluster tool (100).

14. The cluster tool (100) according to claim 2, wherein
the robot (104) is configured to transfer the one or more substrates between the main, the load, the fluid deposition, the low temperature cure, and the high temperature cure chambers

15. The cluster tool (100) of any preceding claim, wherein the environmental controller is configured to maintain a substantially moisture-free, pure nitrogen environment inside the cluster tool (100).

16. The cluster tool (100) of any preceding claim, wherein the environmental controller is configured to maintain an inert, an oxidizing, a low Rh, or a high Rh environment inside the cluster tool (100).

17. The cluster tool (100) of any preceding claim, wherein the load chamber (106) must be equilibrated to the environment of the main chamber (102) before the interior door of the load chamber (106) is opened to allow transfer of substrates between the load chamber (106) and the main chamber (102).

18. A method of depositing a fluid on a substrate comprising:
maintaining a substantially autonomous environment within a cluster tool (100), the cluster tool (100) comprising a main chamber (102) including a robot (104), a load chamber (106) coupled to the main chamber (102), and a fluid deposition chamber (108) coupled to the main chamber (102), the autonomous environment permitting fluid deposition operations to occur under controlled conditions;
loading one or more substrates into the load chamber (106);
equilibrating an environment inside the load chamber (106) with an environment inside the main chamber (102);
using the robot (104) to transfer at least one of the one or more substrates from the load chamber (106) into the fluid deposition chamber (108), the fluid deposition chamber (108) including an inkjet printer fluid deposition device (307) configured to deposit fluid onto the one or more substrates; and
depositing fluid from the fluid deposition device onto the at least one substrate.

19. The method of claim 18, the cluster tool (100) further including a low temperature cure chamber and a high temperature cure chamber, the method further comprising:
using the robot (104) to transfer the at least one substrate from the fluid deposition chamber (108) into the low temperature cure chamber;
performing a low temperature cure operation on the at least one substrate;
using the robot (104) to transfer the at least one substrate from the fluid deposition chamber (108) into the high temperature cure chamber;
performing a high temperature cure operation on the at least one substrate; using the robot (104) to transfer the at least one substrate from the high temperature cure chamber into the load chamber (106); and
unloading the at least one substrate from the load chamber (106).

20. The method of claim 18, further comprising:
while a first substrate is in the low temperature cure chamber, using the robot (104) to transfer a second substrate from the load chamber (106) into the fluid deposition chamber (102), where the fluid deposition operation occurs at least in part on the second substrate while the low temperature cure operation occurs on the first substrate.

21. The method of any one of claims 18 to 20 wherein the substantially autonomous environment is a substantially moisture-free, pure nitrogen enviromnent.

## Patentansprüche

1. Clustertool (100) umfassend:
eine Hauptkammer (102);
eine Ladekammer (106), gekoppelt an die Hauptkammer (102) und ausgelegt, um ein oder mehrere Substrate aufzunehmen;
eine Fluid-Auftrag-Kammer (108), gekoppelt an die Hauptkammer (102), wobei die Fluid-Auftrag-Kammer (108) die eine Tintenstrahldrucker-Fluid-Auftrag-Vorrichtung (307) beinhaltet, ausgelegt, um Fluid auf das eine oder die mehreren Substrate aufzutragen;
einen Roboter (104), beinhaltet in der Hauptkammer (102), wobei der Roboter (104) ausgelegt ist, um das eine oder die mehreren Substrate zwischen der Ladekammer (106) und der Fluid-Auftrag-Kammer (108) zu transferieren; und
einen Umgebungscontroller (110), ausgelegt, um eine im Wesentlichen autonome Umgebung innerhalb des Clustertools, das die Haupt-, die Lade- und die Fluid-Auftrag-Kammer beinhaltet aufrecht zu halten, wobei die autonome Umgebung Fluid-Auftrag-Vorgänge ermöglicht, die unter kontrollierten Bedingungen stattfinden.

2. Clustertool (100) nach Anspruch 1, weiter umfassend:
eine Niedrigtemperatur-Härtekammer (112), gekoppelt an die Hauptkammer und ausgelegt, um einen Niedrigtemperatur-Härtevorgang bei dem einen oder den mehreren Substraten durchzuführen; und
eine Hochtemperatur-Härtekammer (114), gekoppelt an die Hauptkammer und ausgelegt, um einen Hochtemperatur-Härtevorgang bei dem einen oder den mehreren Substraten durchzuführen.

3. Clustertool (100) nach irgendeinem vorangehenden Anspruch, wobei die Ladekammer (106) eine Innentür beinhaltet, die an die Hauptkammer (102) gekoppelt ist und eine oder mehrere Außenseiten, wobei die Ladekammer (106) ausgelegt ist, um das eine oder die mehreren Substrate durch eine Außentür in zumindest einer der einen oder mehreren Außenseiten aufzunehmen.

4. Clustertool (100) nach irgendeinem vorangehenden Anspruch, wobei die Fluid-Auftrag-Kammer (108) eine Innenöffnung beinhaltet, gekoppelt an die Hauptkammer und eine oder mehrere Außenseiten, wobei es der Öffnung an einer Tür mangelt.

5. Clustertool (100) nach irgendeinem vorangehenden Anspruch, wobei die Fluid-Auftrag-Kammer (108) einen Rapid-Transfer-Port beinhaltet.

6. Clustertool (100) nach irgendeinem vorangehenden Anspruch, wobei die Fluid-Auftrag-Kammer (108) einen oder mehrere Handschuhe beinhaltet, die mit der einen oder den mehreren Außenseiten dicht verbunden sind und sich in die Fluid-Auftrag-Kammer (108) erstrecken.

7. Clustertool (100) nach irgendeinem vorangehenden Anspruch, wobei der Umgebungscontroller (110) ein Gasreinigungssystem (626) beinhaltet, ausgelegt, um eine Gaszusammensetzung innerhalb der Kammern, die in dem Clustertool (100) beinhaltet sind, zu steuern.

8. Clustertool (100) nach Anspruch 7, wobei der Umgebungscontroller (110) weiter einen Prozessor (624, 420) beinhaltet, ausgelegt, um das Gasreinigungssystem (626) mit Steuersignalen zu versorgen, um die Gaszusammensetzung innerhalb der Kammern des Clustertools (100) zu steuern.

9. Clustertool (100) nach einem der Ansprüche 7 oder 8, wobei das Steuern der Gaszusammensetzung innerhalb der Kammer des Clustertools (100) das Steuern eines Feuchtigkeitslevels innerhalb der Kammern des Clustertools (100) umfasst.

10. Clustertool (100) nach irgendeinem der Ansprüche 7, 8 oder 9, wobei das Gas innerhalb des Clustertools (100) fortwährend wieder durch das Clustertool (100) und das Gasreinigungssystem (626) in Umlauf gebracht wird.

11. Clustertool (100) nach irgendeinem vorangehenden Anspruch, weiter umfassend einen Prozessor, ausgelegt, um Steuersignale für den Roboter (104) bereitzustellen.

12. Clustertool (100) nach Anspruch 11, wobei der Prozessor weiter dafür ausgelegt ist, um Steuersignale für eine oder mehrere der Kammern, die an die Hauptkammer des Clustertools (100) gekoppelt sind, bereitzustellen.

13. Clustertool (100) nach irgendeinem vorangehenden Anspruch, weiter umfassend:
eine Mensch-Maschine-Schnittstelle (622), ausgelegt, um Benutzereingaben aufzunehmen, um das Clustertool (100) zu steuern.

14. Clustertool (100) nach Anspruch 2, wobei
der Roboter (104) ausgelegt ist, um das eine oder die mehreren Substrate zwischen den Haupt-, Lade-, Fluid-Auftrag-, Niedrigtemperatur-Härte-und Hochtemperatur-Härtekammern zu transferieren.

15. Clustertool (100) nach irgendeinem vorangehenden Anspruch, wobei der Umgebungscontroller ausgelegt ist, um eine im Wesentlichen feuchtigkeitsfreie, reine Stickstoff-Umgebung innerhalb des Clustertools (100) aufrecht zu halten.

16. Clustertool (100) nach irgendeinem vorangehenden Anspruch, wobei der Umgebungscontroller ausgelegt ist, um eine inerte, eine oxidierende, eine niedrig Rh oder eine hoch Rh Umgebung innerhalb des Clustertools (100) aufrecht zu halten.

17. Clustertool (100) nach irgendeinem vorangehenden Anspruch, wobei die Ladekammer (106) mit der Umgebung der Hauptkammer (102) ins Gleichgewicht gebracht werden muss, bevor die Innentür der Ladekammer (106) geöffnet wird, um den Transfer von Substraten zwischen der Ladekammer (106) und der Hauptkammer (102) zu ermöglichen.

18. Verfahren zum Auftragen eines Fluids auf ein Substrat, umfassend:
Aufrechthalten einer im Wesentlichen autonomen Umgebung innerhalb eines Clustertools (100), wobei das Clustertool (100) eine Hauptkammer (102), die einen Roboter (104) beinhaltet, eine Ladekammer (106), gekoppelt an die Hauptkammer (102) und eine Fluid-Auftrag-Kammer (108), gekoppelt an die Hauptkammer (102), umfasst, wobei die autonome Umgebung Fluid-Auftrag-Vorgänge ermöglicht, die unter kontrollierten Bedingungen stattfinden;
Laden eines oder mehrerer Substrate in die Ladekammer (106);
ins Gleichgewicht bringen der Umgebung innerhalb der Ladekammer (106) mit der Umgebung innerhalb der Hauptkammer (102);
Benutzen des Roboters (104), um mindestens eines des einen oder der mehreren Substrate von der Ladekammer (106) in die Fluid-Auftrag-Kammer (108) zu transferieren, wobei die Fluid-Auftrag-Kammer (108) eine Tintenstrahldrucker-Fluid-Auftrag-Vorrichtung (307) beinhaltet, ausgelegt, um Fluid auf das eine oder die mehreren Substrate aufzutragen; und
Auftragen von Fluid von der Fluid-Auftrag-Vorrichtung auf das mindestens eine Substrat.

19. Verfahren nach Anspruch 18, wobei das Clustertool (100) weiter eine Niedrigtemperatur-Härtekammer und eine Hochtemperatur-Härtekammer beinhaltet, wobei das Verfahren weiter umfasst:
Benutzen des Roboters (104), um das mindestens eine Substrat von der Fluid-Auftrag-Kammer (108) in die Niedrigtemperatur-Härtekammer zu transferieren;
Durchführen eines Niedrigtemperatur-Härtevorgangs an dem mindestens einen Substrat;
Benutzen des Roboters (104), um das mindestens eine Substrat von der Fluid-Auftrag-Kammer (108) in die Hochtemperatur-Härtekammer zu transferieren;
Durchführen eines Hochtemperatur-Härtevorgangs an dem mindestens einen Substrat;
Benutzen des Roboters (104), um das mindestens eine Substrat von der Hochtemperatur-Härtekammer in die Ladekammer (106) zu transferieren; und
Entladen des mindestens einen Substrats von der Ladekammer (106).

20. Verfahren nach Anspruch 18, weiter umfassend:
während ein erstes Substrat in der Niedrigtemperatur-Härtekammer ist, Benutzen des Roboters (104), um ein zweites Substrat von der Ladekammer (106) in die Fluid-Auftrag-Kammer (102) zu transferieren, wo der Fluid-Auftrag-Vorgang auf dem zweiten Substrat zumindest teilweise stattfindet während der Niedrigtemperatur-Härtevorgang an dem ersten Substrat stattfindet.

21. Verfahren nach irgendeinem der Ansprüche 18-20, wobei die im Wesentlichen autonome Umgebung eine im Wesentlichen feuchtigkeitsfreie, reine Stickstoff-Umgebung ist.

## Revendications

1. Outil combiné (100), comprenant:
une chambre principale (102) ;
une chambre de chargement (106) couplée à la chambre principale (102) et conçue pour recevoir un ou plusieurs substrats ;
une chambre de dépôt de fluide (108) couplée à la chambre principale (102), la chambre de dépôt de fluide (108) comportant un dispositif de dépôt de fluide type imprimante à jet d'encre (307) conçu pour déposer du fluide sur le ou les substrats ;
un robot (104) incorporé dans la chambre principale (102), le robot (104) étant conçu pour transférer le ou les substrats entre la chambre de chargement (106) et la chambre de dépôt de fluide (108) ; et
un régulateur de milieu (110) conçu pour maintenir un milieu sensiblement autonome à l'intérieur de l'outil combiné contenant les chambres principale, de chargement et de dépôt de fluide, le milieu autonome permettant la mise en oeuvre d'opérations de dépôt de fluide dans des conditions régulées.

2. Outil combiné (100) selon la revendication 1, comprenant en outre :
une chambre de séchage à basse température (112) couplée à la chambre principale et conçue pour mettre en oeuvre une opération de séchage à basse température sur le ou les substrats ; et
une chambre de séchage à haute température (114) couplée à la chambre principale et conçue pour mettre en oeuvre une opération de séchage à haute température sur le ou les substrats.

3. Outil combiné (100) selon l'une quelconque des revendications précédentes, dans lequel la chambre de chargement (106) comporte un clapet intérieur couplé à la chambre principale (102) et une ou plusieurs faces extérieures, dans lequel la chambre de chargement (106) est conçue pour recevoir le ou les substrats par un clapet extérieur dans la ou au moins une des faces extérieures.

4. Outil combiné (100) selon l'une quelconque des revendications précédentes, dans lequel la chambre de dépôt de fluide (108) comporte une ouverture intérieure couplée à la chambre principale et une ou plusieurs faces extérieures, l'ouverture étant dépourvue d'un clapet intérieur.

5. Outil combiné (100) selon l'une quelconque des revendications précédentes, dans lequel la chambre de dépôt de fluide (108) comporte un accès de transfert rapide.

6. Outil combiné (100) selon l'une quelconque des revendications précédentes, dans lequel la chambre de dépôt de fluide (108) comporte un ou plusieurs gants fixés de manière étanche à une ou plusieurs des faces extérieures et pénétrant dans la chambre de dépôt de fluide (108).

7. Outil combiné (100) selon l'une quelconque des revendications précédentes, dans lequel le régulateur de milieu (110) comporte un système d'épuration de gaz (626) conçu pour réguler une composition gazeuse à l'intérieur des chambres incorporées dans l'outil combiné (100).

8. Outil combiné (100) selon la revendication 7, dans lequel le régulateur de milieu (110) comporte en outre un processeur (624, 420) conçu pour fournir des signaux de régulation au système d'épuration de gaz (626) afin de réguler la composition gazeuse présente à l'intérieur des chambres de l'outil combiné (100).

9. Outil combiné (100) selon la revendication 7 ou 8, dans lequel la régulation de la composition gazeuse à l'intérieur des chambres incorporées dans l'outil combiné (100) comprend la régulation d'un taux d'humidité à l'intérieur des chambres incorporées dans l'outil combiné (100).

10. Outil combiné (100) selon l'une quelconque des revendications 7, 8 ou 9, dans lequel le gaz à l'intérieur de l'outil combiné (100) est constamment remis en circulation à travers l'outil combiné (100) et à travers le système d'épuration de gaz (626).

11. Outil combiné (100) selon l'une quelconque des revendications précédentes, comprenant en outre un processeur conçu pour fournir des signaux de commande au robot (104).

12. Outil combiné (100) selon la revendication 11, dans lequel le processeur est en outre conçu pour fournir des signaux de commande à une ou plusieurs des chambres couplées à la chambre principale incorporée dans l'outil combiné (100).

13. Outil combiné (100) selon l'une quelconque des revendications précédentes, comprenant en outre :
une interface homme-machine (622), conçue pour recevoir une entrée d'utilisateur pour commander l'outil combiné (100).

14. Outil combiné (100) selon la revendication 2, dans lequel le robot (104) est conçu pour transférer le ou les substrats entre les chambres principale, de chargement, de dépôt de fluide, de séchage à basse température et de séchage à haute température.

15. Outil combiné (100) selon l'une quelconque des revendications précédentes, dans lequel le régulateur de milieu est conçu pour maintenir un milieu sensiblement à azote pur et exempt d'humidité à l'intérieur de l'outil combiné (100).

16. Outil combiné (100) selon l'une quelconque des revendications précédentes, dans lequel le régulateur de milieu est conçu pour maintenir un milieu inerte, un milieu oxydant, un milieu à faible humidité relative ou un milieu à forte humidité relative à l'intérieur de l'outil combiné (100).

17. Outil combiné (100) selon l'une quelconque des revendications précédentes, dans lequel la chambre de chargement (106) doit être mise en équilibre avec le milieu de la chambre principale (102) préalablement à l'ouverture du clapet intérieur de la chambre de chargement (106) pour permettre le transfert de substrats entre la chambre de chargement (106) et la chambre principale (102).

18. Procédé pour déposer un fluide sur un substrat, le procédé comprenant les étapes consistant à :
maintenir un milieu sensiblement autonome à l'intérieur d'un outil combiné (100), l'outil combiné (100) comprenant une chambre principale (102) comportant un robot (104), une chambre de chargement (106) couplée à la chambre principale (102) et une chambre de dépôt de fluide (108) couplée à la chambre principale (102), le milieu autonome permettant la mise en oeuvre d'opérations de dépôt de fluide dans des conditions régulées ;
charger un ou plusieurs substrats dans la chambre de chargement (106) ;
mettre en équilibre un milieu à l'intérieur de la chambre de chargement (106) avec un milieu à l'intérieur de la chambre principale (102) ;
utiliser le robot (104) pour transférer le ou au moins un des substrats de la chambre de chargement (106) à la chambre de dépôt de fluide (108), la chambre de dépôt de fluide (108) comportant un dispositif de dépôt de fluide type imprimante à jet d'encre (307) conçu pour déposer du fluide sur le ou les substrats ; et
déposer sur le ou les substrats du fluide provenant du dispositif de dépôt de fluide.

19. Procédé selon la revendication 18, l'outil combiné (100) comprenant en outre une chambre de séchage à basse température et une chambre de séchage à haute température, le procédé comprenant en outre les étapes consistant à :
utiliser le robot (104) pour transférer le ou les substrats de la chambre de dépôt de fluide (108) à la chambre de séchage à basse température ;
mettre en oeuvre une opération de séchage à basse température sur le ou les substrats ;
utiliser le robot (104) pour transférer le ou les substrats de la chambre de dépôt de fluide (108) à la chambre de séchage à haute température ;
mettre en oeuvre une opération de séchage à haute température sur le ou les substrats ;
utiliser le robot (104) pour transférer le ou les substrats de la chambre de séchage à haute température à la chambre de chargement (106) ; et
décharger le ou les substrats de la chambre de chargement (106).

20. Procédé selon la revendication 18, comprenant en outre l'étape consistant à :
utiliser le robot (104) pour transférer un deuxième substrat de la chambre de chargement (106) à la chambre de dépôt de fluide (102) alors qu'un premier substrat se trouve dans la chambre de séchage à basse température, l'opération de dépôt de fluide étant mise en oeuvre au moins en partie sur le deuxième substrat alors que l'opération de séchage à basse température est mise en oeuvre sur le premier substrat.

21. Procédé selon l'une quelconque des revendications 18 à 20, dans lequel le milieu sensiblement autonome est un milieu sensiblement à azote pur et exempt d'humidité.
